# EUROPEAN PATENT SPECIFICATION

(11) **EP 0 375 465 B1**
(45) Date of publication and mention of the grant of the patent: **14.02.1996**
(21) Application number: 89313570.7
(22) Date of filing: 22.12.1989
(51) Int. Cl.: H01L 39/24, H01L 39/10, H01L 39/22

(54) **Superconducting tunnel junction radiation sensing device and Josephson device**
Supraleitende strahlungsempfindliche Vorrichtung mit Tunnelübergang, und Josephson Element
Dispositif radiosensible supraconducteur à jonction tunnel et dispositif Josephson

(30) Priority: 23.12.1988 JP 323504/88; 05.09.1989 JP 229547/89
(43) Date of publication of application: 27.06.1990
(73) Proprietor: NIPPON STEEL CORPORATION, Tokyo 100 (JP)
(72) Inventor: Kurakado, Masahiko c/o R & D Laboratories-I, Kawasaki-shi Kangawa-ken (JP); Matsumura, Atsuki c/o R & D Laboratories-I, Kawasaki-shi Kangawa-ken (JP); Kaminaga, Takeshi c/o R & D Laboratories-I, Kawasaki-shi Kangawa-ken (JP); Takahashi, Tooru c/o R & D Laboratories-I, Kawasaki-shi Kangawa-ken (JP)
(74) Representative: Rees, David Christopher

(56) References cited:
- IEEE TRANSACTIONS ON MAGNETICS, vol. 25, no. 2, March 1989, pages 1354-1357, IEEE, New York, US ; & APPLIED SUPERCONDUCTIVITY CONFERENCE, San Francisco, 21st-25th August 1988, IEEE Magnetics Society, US; K. ISHIBASHI et al.: "Characteristics of Nb-based Josephson junctions at a temperature below 1K"
- JOURNAL OF APPLIED PHYSICS, vol. 64, no. 3, 1st August 1988, pages 1586-1688, American Institute of Physics, New York, US; T. IMAMURA et al.: "A submicrometer Nb/AIOx/Nb Josephson junction"
- JOURNAL OF APPLIED PHYSICS, vol. 61, no. 1, 1st January 1987, pages 1-7, American Institute of Physics, New York, US; D. TWERENBOLD et al.: "Superconducting Sn/Sn-oxide tunneling junctions as high-resolution x-ray detectors"
- JAPANESE JOURNAL OF APPLIED PHYSICS, vol. 25, no. 5, May 1986, pages L343-L345, Tokyo, JP; J. NIEMEYER et al.: "Nb/Al-oxide/Nb and NbN/MgO/NbN tunnel junctions in large series arrays for voltage standards"
- PATENT ABSTRACTS OF JAPAN, vol. 11, no. 5 (E-486)[2520], 5th March 1987; & JP-A-61 228 685
- JAPANESE JOURNAL OF APPLIED PHYSICS, vol. 28, no. 3, March 1989, pages L459- L461, Tokyo, JP; M. KURAKADO et al.: "X-ray detection with Nb/AlOx/Nb superconductor detectors"

## Description

This invention relates to a radiation sensing device and a Josephson device. More particularly, this invention relates to a device for the detection of nuclear radiation, light, etc, by the use of a superconducting tunnel junction, an arithmetic device, and a Josephson device used as for the detection of microwaves.

A radiation sensing device using a superconducting tunnel junction may possess an energy decomposition capacity some tens of times as high as that of a conventional semiconductive sensing device. The development of such radiation sensing devices has been under way in recent years [Applied Physics, Vol. 53, No. 6, pages 532-537 1984) and A. Barone "Superconductive Particle Detectors," (1988), World Scientific] .

Light is an electromagnetic wave similar to X-ray radiation. A photosensor using a superconductive tunnel junction could become highly sensitive to light of wavelengths in a wide range from the far-infrared to the ultraviolet zone.

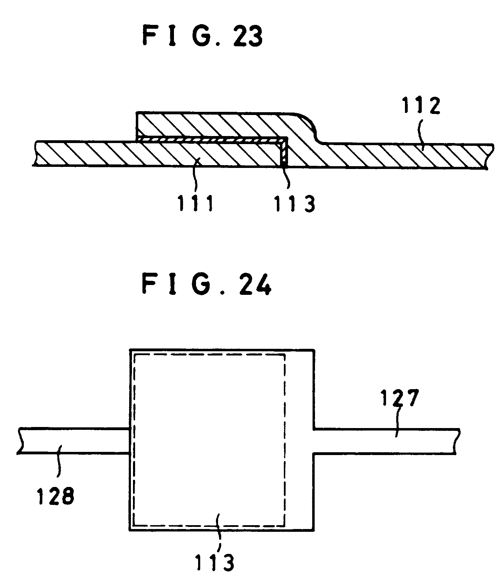

Heretofore, as a device for the detection of radiations such as X-rays and light by the use of a superconducting tunnel junction, a device configured as illustrated in Figure. 23 and Fig. 24 has been developed.

In the sensing device illustrated in Fig. 23 and Fig. 24, a thin insulating layer (tunnel barrier layer) 113 is laid throughout the entire junction between a superconductor 111 serving as a lower electrode and a superconductor 112 constituting itself a counter electrode so shaped as to enclose the upper surface and one lateral surface of the superconductor 111 serving as the lower electrode. In Fig. 24, the reference numeral 127 denotes an upper wiring and the reference numeral 128 a lower wiring respectively.

For the radiation sensing device or the photosensor to be improved in performance, the surface area of the superconductor destined to serve as an absorbent for the energy of radiation or photon must be increased for enhancing the efficiency of detection of radiation or photon. In the device configured as illustrated in Fig. 23 and Fig. 24, such an increase in the surface area entails the problem that the electrostatic capacity of the tunnel junction increases and the detection signal of radiation or photon decreases proportionately.

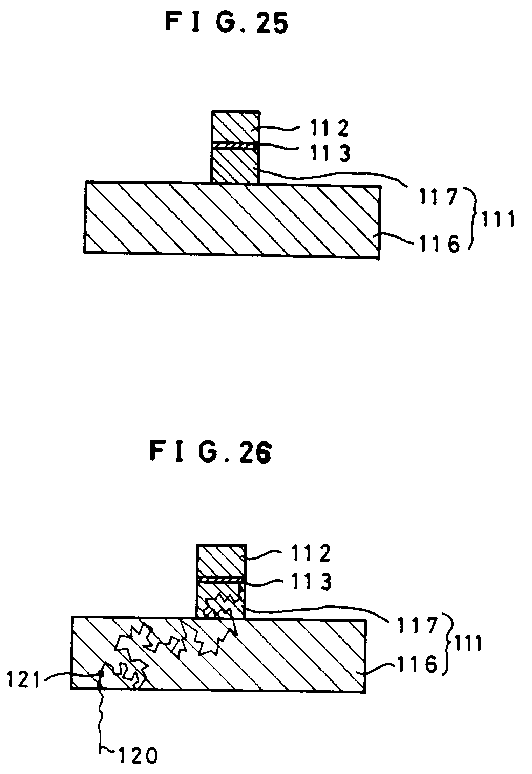

Booth, for the purpose of solving this problem, has proposed a device possessing such a cross-sectional structure as illustrated in Fig. 25 [Applied Physics Letters, Vol. 50, No. 5, pages 293-295 (1987)]. To be specific, it is a superconducting tunnel junction device which is produced by using as a lower electrode side superconductor 111, a composite having superposed on the central part of a superconductive layer 116 of a large surface area, a superconductive layer 117 of a small surface area possessing a smaller energy gap than the superconductive layer 116, forming an insulating layer 113 on the upper surface of the superconductive layer 117 of the small surface area, and superposing on the insulating layer 113, a superconductor 112 serving as a counter electrode. This device is enabled to restrain the electrostatic capacity thereof and derive a large detection signal because the insulating layer 113 is allowed to have a smaller surface area than the superconductive layer 116 serving as the absorbent for the energy of radiation or photon. Further, since the superconductive layer 117 having a smaller energy gap than the superconductive layer 116 is joined to the insulating layer 113, the electrons or electron holes excited in the superconductive layer 116 by the absorption of radiation or photon 120 (hereinafter collectively referred to as "excited electrons" for the sake of simplicity) 121, after being diffused inside the superconductive layer 116 and then passed into the superconductive layer 117, are not appreciably returned again to the superconductive layer 116 but are contained within the superconductive layer 117. Since the superconductive layer 117 functions as a trapping layer and continues to trap the excited electrons close to the insulating layer 113, it's probable that the excited electrons 121 penetrate the insulating layer 113 by virtue of the tunnel effect and contribute as signals before recombination.

In the device of such a structure as illustrated in Fig. 25 proposed by Booth, the efficiency of collection of the excited electrons in the superconductive layer 117 is high when the mean free path of the excited electrons within the superconductive layer 116 is not very small as compared with the representative length of the plane of the superconductive layer 116 (such as, for example, the diameter where the plane is circular or the length of the side where the plane is square). Generally, however, it is quite difficult to increase the mean free path of excited electrons within a superconductor beyond the level of some tens of µm. If the mean free path could be sufficiently increased in a bulk superconductor, the mean free path in a superconductor produced in the form of a thin film would be substantially limited by the thickness of the thin film. Thus it is impossible to approximate the mean free path to the representative length of the plane of the superconductive layer 116 in the case of film detectors.

In the structure illustrated in Fig. 26, since the surface area of the superconductive layer 117 destined to serve as a trapping layer is smaller than that of the superconductive layer 116 destined to serve as an absorbent for energy, it is inferred that the excited electrons 121 produced in consequence of the absorption of radiation or photon 120 in the portion of the superconductive layer 116 remote from the superconductive layer 117 require a much longer time in reaching the superconductive layer 117 by diffusion than those produced in the portion rather close to the superconductive layer 117 before they reach the insulating layer 113 as illustrated in Fig. 26. In fact, it is well known that the average time required for the excited electrons 121 to depart from a certain point to a certain distance by diffusion is proportional to the square of this distance. It is also well known that in a superconductor, the electrons and electron holes excited by radiation or photon are eventually recombined [S. B. Kaplan et al, Physical Review B., Vol 14, pages 4,854-4,873 (1976)]. In the tunnel junction device, the excited electrons no longer contribute to signals when they are recombined before they penetrate the insulating layer by virtue of the tunnel effect. Thus, when the energy of the radiation or photon is fixed, the rise time and magnitude of signal are varied by the position of impingement of the radiation or photon. Further, concerning the electrons excited in the portion close to the superconductive layer 117 destined to serve as a trapping layer, there are times when the excited electrons are diffused in the portion of the superconductive layer 116 remote from the superconductive layer 117 before they reach the superconductor layer 117.

In the device structure of Fig. 25, when the surface areas of the insulating layer 113 and that of the superconductor 112 are fixed and the surface area of the superconductive layer 117 is enlarged so much as to equal that of the superconductive layer 116, the average time required for the electrons excited within the superconductive layer 116 to be diffused in the superconductive layer 117 is decreased. In this case, however, the time required by the excited electrons in travelling from the superconductive layer 117 of a larger surface area to the insulating layer 113 of a smaller surface area is increased and, as a result, the probability that they are recombined before they penetrate the insulating layer 113 by virtue of the tunnel effect is increased.

The conventional radiation sensing device has the disadvantage that a significant increase in the surface area for the enhancement of the efficiency of detection is difficult to obtain; a large increase in the surface area results in a decrease in the response speed, and signal rise time and the signal magnitude vary with the position of impingement of radiation or photon.

Further, in a radiation sensing device or the photosensor, it is considered that an addition to the thickness of the superconductor serving as an absorbent for energy is effective in enhancing the efficiency of detection of radiation or light.

It is plain from the description given above that for the radiation sensing device or the photosensor to be highly sensitive, however, the excited electrons produced in the sensor by the impingement of radiation or photon must be passed efficiently through the tunnel barrier layer by virtue of the tunnel effect and taken out of the junction in the form of signal charges. If the excited electrons require a long time in tunnelling through the barrier layer, most of the excited electrons suffer a recombination during this time and are not taken out in the form of signal charges.

When the thickness of the superconductor is increased for the purpose of improving the efficiency of detection of radiation or light and, as a result, the time required by the excited electrons in tunnelling the tunnel barrier layer is caused to increase, there ensues a disadvantage that the efficiency of collection of the excited electrons is degraded.

In fact, in a conventional radiation sensing device, the energy decomposition capacity is seriously degraded by an increase in the thickness of the superconductive layer alone. This phenomenon is ascribable in a large measure to the fact that a conventional radiation sensing device configured as illustrated in Figs. 23 and 24 or Figs. 25 and 26 use superconductors formed invariably of polycrystals.

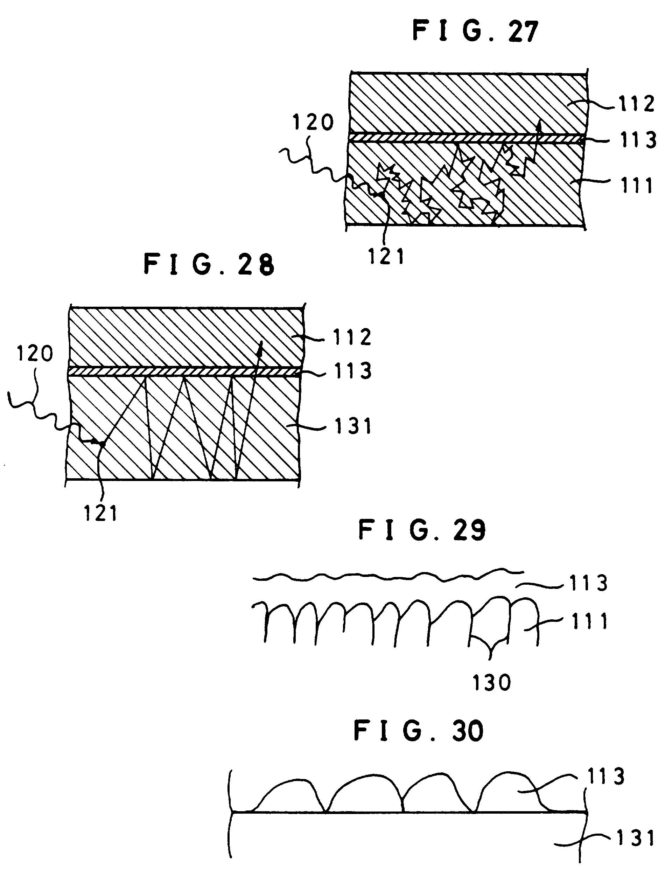

Specifically, in order for the excited electrons 121 produced by the impingement of the radiation or photon 120 to achieve efficient tunnelling through the tunnel barrier layer 113, the excited electrons 121 are desired to be capable of quickly migrating about within the superconductive layer and easily reaching the tunnel barrier layer. As can be understood from Fig. 27 and Fig. 28 which depict the manner of diffusion of excited electrons 121, therefore, the superconductive layer on which the radiation or photon 120 impinges is desired not to be a polycrystalline superconductor 111 but to be a single-crystal superconductor 131 in which the mean free path of excited electrons 121 is long. Incidentally, this fact has been pointed out in the literature [Nuclear Instruments and Method in Physics Research, Vol. 277, P 483 (1983)].

The fact that the superconductor as an energy absorbent is formed of a single-crystal superconductor 131, therefore, is advantageous for the sake of enhancing the efficiency of collection of the excited electrons. In a device which is formed as illustrated in Fig. 28 by using a single-crystal superconductor 131 as a lower superconductive layer and superposing thereon a tunnel barrier layer 113 and an upper superconductive layer 11, there arises a disadvantage that the leak current, i.e. the electric current which flows through defects in the tunnel barrier layer 131 or in the terminal of the tunnel barrier layer 113 instead of depending on the tunnel effect, is increased. The leak current itself constitutes a major source of electric noise. For a radiation sensing device which measures the energy of individual pieces of radiation or light from feeble signal charges, this drawback is fatal.

The superconducting tunnel junction type radiation sensing device resorts to excited electrons as already described and not to the Josephson effect. The operating principle and the method of use of this radiation sensing device are entirely different from those of the microwave sensor using a Josephson junction, for example. In fact, the radiation sensing device as sued is held under an applied magnetic field in order to suppress the Josephson effect. The wiring for this device also necessitates a peculiar construction which is not required in the Josephson junction. Exclusively in terms of the basic configuration of the junction, however, the superconducting tunnel junction device and the tunnel type Josephson junction are substantially identical to each other.

Heretofore, also in the tunnel type Josephson device, polycrystalline superconductors have been used as superconductors. In a device which uses polycrystalline superconductors only as superconductors, however, when the ambient temperature is lowered through the critical temperature, in a weak magnetic field such as geomagnetism, the superconductor is not easily cooled evenly or uniformly in one direction because of numerous grain boundaries present in the polycrystalline material.. Thus, there ensues the possibility that the magnetic field which has been expelled by the Meissner effect from the location already vested with superconductivity is trapped in a location not yet vested with superconductivity and the magnetic flux is consequently trapped in the device (magnetic flux) trapping). Since the occurrence of magnetic flux trapping depends on a delicate change in the manner of cooling occurring in the device, it cannot be easily controlled.

When magnetic flux trapping occurs, the Josephson device can only operate at its optimum with difficulty because there is a decrease in the DC Josephson current.

For the elimination of this problem, the use of single crystals as a superconductor layer has been being tried in a tunnel type Josephson device [IEEE Transactions on Magnetic, Vol. MAG-21, No. 2, p 539 (1985)].

In a tunnel type Josephson device which uses single crystals as superconductors on the input side, it is believed that magnetic flux trapping does not easily occur in one direction and, as a result, the magnetic flux is completely expelled from the device. Where the Josephson device is formed as illustrated in Fig. 28 by using a single-crystal superconductor 131 as a lower superconductive layer and superposing thereon a tunnel barrier layer 113 and an upper superconductive layer 112, there inevitably ensues a disadvantage that the leak current, i.e. the electric current which flows through the defects in the tunnel barrier layer 113 or in the terminal part of the tunnel barrier layer 113 without recourse to the Josephson effect, increases similarly to the aforementioned radiation sensing device. Even in a Josephson device, the leak current poses a serious problem that the probability of the device producing an erroneous operation will be increased.

An object of this invention, therefore, is to provide a novel radiation sensing device both novel and free from the problems of prior art mentioned above.

Another object of this invention is to provide a radiation sensing device using a superconducting tunnel junction adapted for significant addition to the surface area of the superconductor destined to serve as an absorbent for the energy of radiation or photon.

Yet another object of this invention is to provide a radiation sensing device using a superconducting tunnel junction possessing a small electrostatic capacitance and exhibiting high efficiency of the detection of radiation or photon.

Still another object of this invention is to provide a radiation sensing device using a superconducting tunnel junction excelling in efficiency of the collection of excited electrons, suffering only from a small leak current, and manifesting a high decomposition capacity.

A further object of this invention is to provide a tunnel type Josephson device which does not readily cause a trapping of magnetic flux.

According to the invention, there is provided a superconducting tunnel junction radiation sensing device comprising a superconductor-tunnel barrier-superconductor structure, the radiation sensing device being characterised in that part of the tunnel barrier layer is formed of a thin-wall part made of an insulator 0.5 to 10 nm (5 to 100 Å) in thickness or a semiconductor 0.5 to 100 nm (5 to 1,000 Å) in thickness, and the other part of the barrier layer is formed of a thick-wall part made of an insulator or a semiconductor having a thickness at least twice as great as that of the thin-wall part; the thin-wall part being uniformly distributed discontinuously or continuously throughout the entire tunnel barrier layer; and the thin-wall part having a smaller total surface area than the thick-wall part.

Preferably, either or both of the superconductors disposed on both sides of the tunnel barrier layer are each formed by superposing two or more superconductive layers of different magnitudes of energy gap in such a manner that the closer the superconductive layer is to the tunnel barrier layer, the smaller is the magnitude of energy gap of the superconductive layer.

According to a second aspect of the invention there is provided a superconducting tunnel junction radiation sensing device comprising a superconductor-tunnel barrier-semiconductor structure, the radiation sensing device characterised in that part of the tunnel barrier layer is formed of a thin-wall part made of an insulator 0.5 to 10 nm (5 to 100 Å) in thickness or a semiconductor 0.5 to 100 nm (5 to 1,000 Å) in thickness, and the other part of the barrier layer is formed of a thick-wall part made of an insulator or a semiconductor having a thickness at least twice as great as that of the thin-wall part; the thin-wall part being uniformly distributed discontinuously or continuously throughout the entire tunnel barrier layer; and the thin-wall part having a smaller total surface area than the thick-wall part.

As with the first aspect of the invention, the superconductor may preferably be formed by the superposition of two or more superconductive layers of different magnitude of energy gap in such manner that the closer the superconductive layer is to the tunnel barrier layer, the smaller is the magnitude of energy gap of the superconductive layer.

The radiation sensing device as the first and second aspects of this invention has the tunnel barrier formed of a thin-wall part and a thick-wall part. It is exclusively the thin-wall part of the tunnel barrier layer that is capable of passing the excited electrons by virtue of the tunnel effect. In contrast, the thick-wall part is incapable of passing the excited electrons, thought it possesses a smaller electrostatic capacity than the thin-wall part. By forming the thin-wall part in a total surface area smaller than that of the thick-wall part (namely by allocating not more than one half of the surface area of the tunnel barrier to the thin-wall part), therefore, the increase in the electrostatic capacity due to an increase in the surface area of device can be restrained. Further by causing the thin-wall part to be uniformly distributed throughout the entire tunnel barrier layer, the distance from the position of excitation of electrons in the superconductive layer to the thin-wall part of the tunnel barrier layer can be restrained within a fixed range of ample shortness without reference to the position of excitation within the superconductor.

Advantageously, the superconducting layer in the second aspect, or one of the superconducting layers in the first aspect may be formed of a single-crystal superconductive layer; a polycrystalline superconductive layer having a thickness not more than one half of the thickness of the single-crystal superconductive layer is formed on the single-crystal superconductive layer in the portion continuous to at least the thin-wall part of the tunnel barrier layer and the polycrystalline superconductive layer adjoins the tunnel barrier layer.

Most preferably, this single-crystal superconductive layer may be formed by superposing two or more single-crystal superconductive layers of different magnitudes of energy gap in such manner that the closer the single-crystal superconductive layer is to the tunnel barrier layer, the smaller is the magnitude of energy gap of the superconductive layer.

The thin-wall part of the tunnel barrier layer according to either of the aspects described may be made of an insulator 0.5 to 3 nm (5 to 30 Å) in thickness and the thick-wall part of the tunnel barrier layer may be made of an insulator or a semiconductor having a thickness of not less than five times the thickness of the thin-wall part.

Preferably, the total surface area of the tunnel barrier layer (S), the total surface area of the thin-wall part (S₁), the maximum value of a plurality of distances (respectively being shortest linear distances in the same horizontal plane from all respective arbitrary points on the thick-wall portion to the thin-wall part) satisfy the following inequality:$\text{O < l <(} \sqrt{\text{S}} \text{-} \sqrt{{\text{S}}_{\text{1}}} \text{) /} \sqrt{\text{π}}$

According to a third aspect of the invention, there is provided a superconducting tunnel junction radiation sensing device comprising a superconductor-tunnel barrier-superconductor structure, characterised in that the superconducting tunnel junction has a lower single-crystal superconductive layer, a polycrystalline superconductive layer of a thickness not more than one half of the thickness of the lower single-crystal superconductive layer, a tunnel barrier layer of a material different from the material of the polycrystalline superconductive layer, and an upper superconductive layer, in the order of increasing distance from the input side of the device.

According to a fourth aspect of the invention, there is provided a superconductive tunnel junction radiation sensing device comprising a superconductor-tunnel barrier-semiconductor structure, characterised in that the superconducting tunnel junction has a lower single-crystal superconductive layer, a polycrystalline semiconductive layer of a thickness not more than one half of the thickness of the lower single-crystal superconductive layer, a tunnel barrier layer of a material different from the material of the polycrystalline semiconductor layer, and an upper superconductive layer, in the order of increasing distance from the input side of the device.

Preferably, the lower single-crystal superconductive layer is either the third or fourth aspects of the invention may be formed by superposing two or more single-crystal superconductive layers of different magnitudes of energy gap in such manner that the closer the single-crystal superconductive layer is to the tunnel barrier layer, the smaller is the magnitude of energy gap of the superconductive layer.

In a most preferred embodiment of the third aspect of the invention, the thickness of the lower single-crystal superconductive layer is greater than the magnetic penetration depth, the sensing device thereby constituting a tunnel-type Josephson device.

We, the inventors conducted a diligent study with a view to elucidating the cause for a large leak current possibly suffered by an device having a tunnel junction formed by directly superposing a tunnel barrier layer and an upper superconductive layer on a single-crystal superconductor as described above. We have consequently drawn an inference that the large leak current is ascribable to the fact that an attempt to form a tunnel barrier layer on a single-crystal superconductor is liable to produce a film lacking uniformity and abounding with pinholes as described more specifically hereinafter. We have found that a tunnel junction structure suffering from only a small leak current and exhibiting a highly satisfactory performance is obtained by forming a polycrystalline superconductive layer of a small thickness on a single-crystal superconductive layer and further superposing thereon a tunnel barrier layer and an upper superconductive layer. The radiation sensing device consequently produced, therefore, combines the highly satisfactory quality of a restrained leak current with the high efficiency of collection of excited electrons as signal charges by virtue of the long mean free path of excited electrons in the single-crystal superconductive layer. By the same token, the Josephson device likewise produced combines the highly satisfactory quality of a restrained leak current with the restraint imposed on the occurrence of magnetic flux trapping owing to the use of the single-crystal superconductor.

In this specification, the word "input side of the device" should be interpreted as the side on which the electrons will be excited.

In the drawings:-
Fig. 1 is a cross section illustrating a typical structure of the first radiation sensing device of this invention;
Fig. 2 is a plan view of the same structure;
Fig. 3 is a cross section typically illustrating the state of diffusion of excited electrons in the same structure;
Figs. 4 to 6 are plan views illustrating other typical structures of the first radiation sensing device of this invention;
Figs. 7 to 10 are cross sections illustrating still other typical structures of the first radiation sensing device of this invention;
Fig. 11 is a cross section illustrating yet another typical structure of the first radiation sensing device of this invention;
Fig. 12 is a cross section illustrating a typical structure of the second radiation sensing device of this invention;
Fig. 13 is a cross section typically illustrating the state of diffusion of excited electrons in the structure of Fig. 12;
Figs. 14 and 15 are cross sections illustrating other typical structures of the second radiation sensing device of this invention;
Fig. 16 is a cross section illustrating a typical structure of the third radiation sensing device of the present invention;
Figs. 17 and 18 are cross sections illustrating yet other typical structures of the third radiation sensing device of this invention;
Figs. 19a to 19d are cross sections illustrating the process flow in the production of the first radiation sensing device of this invention as depicted in a working example;
Fig. 20 is a plan view of the device produced in the working example;
Figs. 21 and 22 are cross sections illustrating the process flow in the production of the second radiation sensing device of this invention as depicted in a working example;
Fig. 23 is a cross section illustrating a typical structure of the conventional radiation sensing device;
Fig. 24 is a plan view of the conventional device;
Fig. 25 is a cross section illustrating another typical structure of the conventional radiation sensing device;
Fig. 26 is a cross section typically illustrating the state of diffusion of excited electrons in the conventional device shown in Fig. 25;
Fig. 27 is a cross section typically illustrating the state of diffusion of excited electrons in the conventional device shown in Fig. 23;
Fig. 28 is a cross section typically illustrating the state of diffusion of excited electrons in the conventional device using a single-crystal superconductor;
Fig. 29 is a cross section typically illustrating the state of a tunnel barrier layer formed on a polycrystalline superconductor;
Fig. 30 is a cross section typically illustrating the state of a tunnel barrier layer formed on a single-crystal superconductor;
Figs. 31a and 31b are graphs showing the current-voltage characteristic of the conventional superconducting tunnel junction using a single-crystal Nb film as a lower superconductor; Fig. 31a representing a junction having Al and Nb for the upper electrode formed by spattering and Fig. 31b a junction having Al and Nb for the upper electrode formed by vacuum evaporation;
Fig. 32 is a graph showing the current-voltage characteristic of the device of the present invention depicted in one working example;
Fig. 33 is a photograph showing the RHEED pattern image of an Al film formed on a single-crystal Nb film;
Fig. 34 is an photograph showing the RHEED pattern image of a single-crystal Nb film;
Fig. 35 is a graph showing the temperature dependency of the magnitudes of current at 1 mV of the conventional device and a typical example of the device of this invention;
Fig. 36 is a graph showing the 5.9 KeV X-ray measuring pulse height spectrum with the conventional device fabricated by the SNEP method; and
Fig. 37 is a graph showing the 5.9 KeV X-ray measuring pulse height spectrum with the device embodying the present invention and fabricated by the SNIP method.

Now, the present invention will be described in detail below with reference to the accompanying drawings.

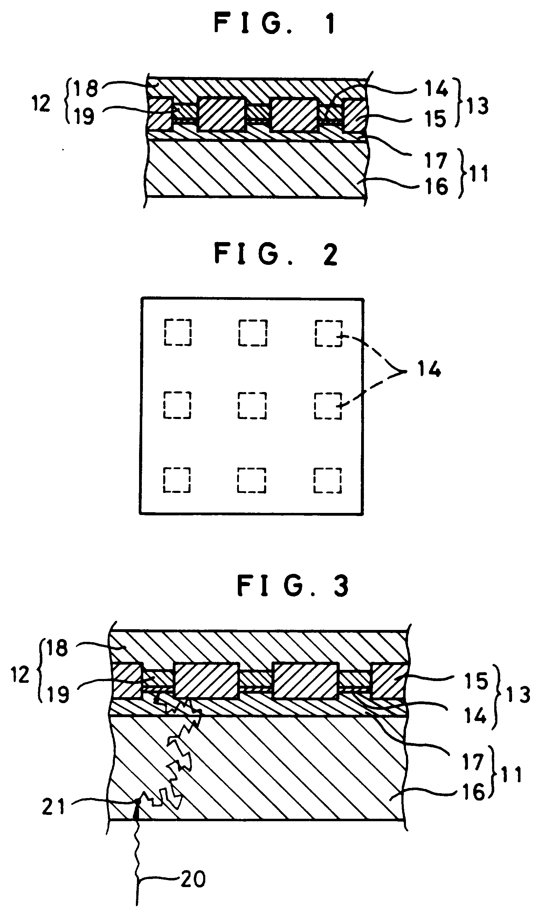

Fig. 1 is a cross section illustrating the typical structure of a radiation sensing device as the first embodiment of this invention and Fig. 2 is a plan view of the same structure.

The radiation sensing device illustrated in Fig. 1 and Fig. 2 possesses a superconductor-tunnel barrier-superconductor structure which has a tunnel barrier layer 13 disposed throughout the entire junction surface between a superconductor 11 destined to serve as a lower electrode and a superconductor 12 destined to serve as a counter electrode. The tunnel barrier layer 13 is composed of a thin-wall part 14 made of a thin insulator or semiconductor and a thick-wall part 15 made of a thick insulator or semiconductor.

In the radiation sensing device of the first embodiment of this invention, the thickness of the thin-wall part 14 of the tunnel barrier layer 13 is in the range of 0.5 to 10 nm (5 to 100 Å), preferably 0.5 to 3 nm (5 to 30 Å), where the part is made of an insulator or in the range of 0.5 to 100 nm (5 to 1,000 Å), preferably 1 to 10 nm (10 to 100 Å), where the part is made of a semiconductor. The reason for this specific range of thickness is that the thin-wall part 14 of the film is not easily produced with substantial uniformity when the thickness of the thin-wall part is less than the lower limit of the range and the passage of electrons by virtue of the tunnel effect is not obtained in the thin-wall part 14 when the thickness exceeds the upper limit of the range.

The thickness of the thick-wall part 15 in the tunnel barrier layer 13 is not less than two times, preferably not less than five times, that of the insulator or the semiconductor forming the thin-wall part 14 mentioned above. The reason for this lower limit of thickness is that the electrostatic capacity per unit surface area of the thick-wall part 15 does not differ distinctly from that of the insulator or the semiconductor forming the thin-wall part 14 and the merit of the provision of the thick-wall part 15 is not acquired when the thickness is less than two times that of the thin-wall part 14.

The total surface area of the thin-wall part 14 is smaller than that of the thick-wall part 15. The reason for the requirement that, in the radiation sensing device as the first embodiment of this invention, the total surface area of the thin-wall part 14 should be smaller than that of the thick-wall part 15 is that if the total surface area of the thin-wall part 14 were larger than that of the thick-wall part 15, the electrostatic capacity of the device would be short of one half of that of a device whose tunnel barrier layer 13 is made solely of a thin insulator or semiconductor and, therefore, the merit otherwise acquired by providing the tunnel barrier layer 13 with the thin-wall part 14 and the thick-wall part 15 in precluding the electrostatic capacity from being increased in consequence of an increase in the surface area would not be produced.

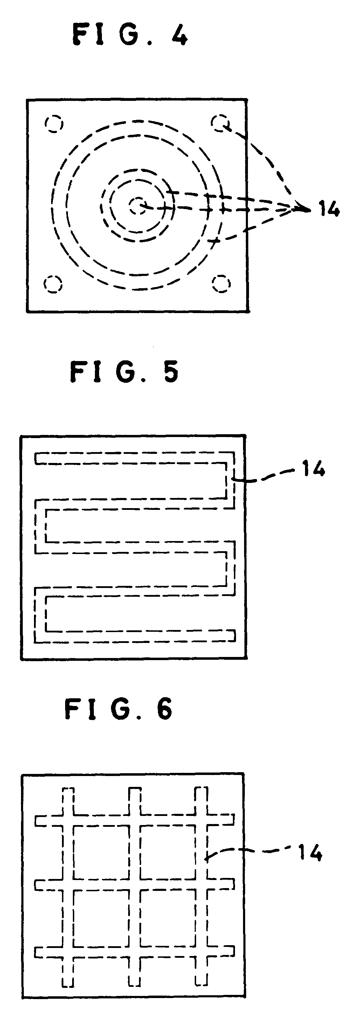

In the typical structure illustrated in Figs. 1 and 2, the thin-wall part 14 is formed of a plurality of small square pieces which are substantially uniformly arranged throughout the entire tunnel barrier layer 13. Thus, the first radiation sensing device of this invention is required to have the thin-wall part 14 substantially uniformly distributed throughout the entire tunnel barrier layer 13 in order to enhance the efficiency of collection of excited electrons or electron holes in the thin-wall part 14 serving as a substantial tunnel barrier. The pattern in which the component square pieces of the thin-wall part 14 are disposed is not limited to that which is illustrated in Fig. 2. The square pieces of the thin-wall part 14 may be formed in the tunnel barrier layer 13 as disposed discontinuously or continuously in a varying pattern so long as the distance from a given position of the occurrence of electron excitation on the superconductor 11 (or the superconductor 12) due to the absorption of radiation or photon to the nearest thin-wall part 14 falls within a desired range. For example, they may be disposed in any of the patterns illustrated in Figs. 4 to 6.

Further, in this respect, the condition of the following expression is desired to be fulfilled:$\text{ℓ < (} \sqrt{\text{S}} \text{-} \sqrt{{\text{S}}_{\text{1}}} \text{)/} \sqrt{\text{π}}$ wherein S stands for the total surface area of the tunnel barrier layer 13, S₁ for the total surface area of the thin-wall part 14, and ℓ for the maximum value of the shortest linear distance from a given point on the tunnel barrier layer to the thin-wall part 14. The reason for this specific condition is that since the condition,$\text{ℓ = (} \sqrt{\text{S}} \text{-} \sqrt{{\text{S}}_{\text{1}}} \text{)/} \sqrt{\text{π}}$ is satisfied where the thin-wall part 14 of the total surface area of S₁ is disposed in the form of one circular figure at the centre of the tunnel barrier layer 13 of a circular figure having the total area of S, the thin-wall layer 14 under the condition,$\text{ℓ ≧ (} \sqrt{\text{S}} \text{-} \sqrt{{\text{S}}_{\text{1}}} \text{)/} \sqrt{\text{π}} \text{,}$ can hardly be called as substantially uniformly distributed throughout the entire tunnel barrier layer 13.

In the radiation sensing device of the typical structure illustrated in Figs. 1 and 2, the superconductor 11 and the superconductor 12 are each depicted as a laminated structure composed of two layers. To be specific, the superconductor 11 comprises a first superconductive layer 16 on the outer side and a second superconductive layer 17 having a smaller energy gap than the first superconductive layer 16 and located on the inner side both relative to the tunnel barrier layer 13. The superconductor 12 likewise comprises a first superconductive layer 18 on the outer side and a second superconductive layer 19 having a smaller energy gap than the first superconductive layer 18 on the inner side both relative to the tunnel barrier layer 13. The fact that, in the radiation sensing device of the first embodiment of this invention, the superconductors are each formed by having at least two superconductive layers with different magnitudes of energy gap superposed in such a manner that the magnitudes of energy gap decreases as the distances of the superconductive layers from the tunnel barrier layer decrease, is desirable from the standpoint of enhancing the efficiency of collection of excited electrons in the thin-wall part of the tunnel barrier layer by virtue of the trap effect. The excited electrons produced in the outer superconductive layer in consequence of the absorption of radiation or photon are diffused inside the outer superconductive layer and passed into the inner superconductive layer and then, owing to the large difference in energy gap, are trapped within the inner superconductive layer without being appreciably returned back to the outer superconductive layer and are continuously trapped near the thin-wall part of the tunnel barrier layer.

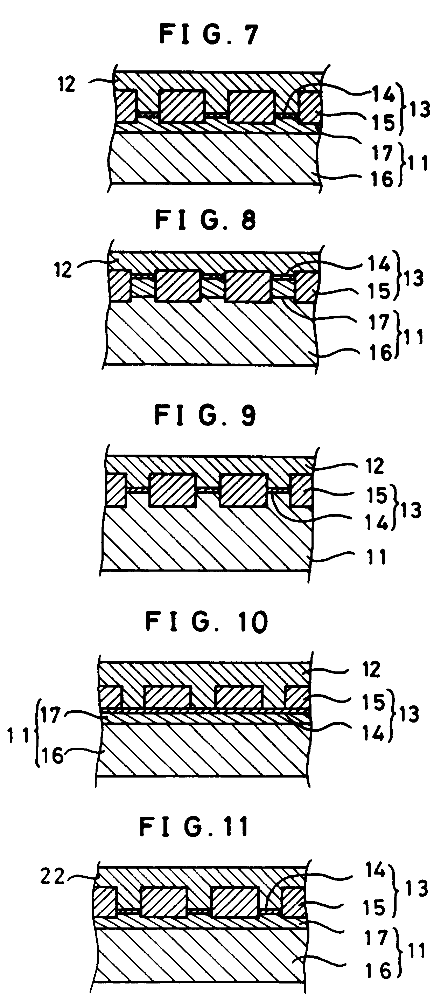

In the radiation sensing device of this invention, however, both of the superconductors 11 and 12 in the superconductor-tunnel barrier-superconductor structure are not required to be formed in a laminated structure as in the typical structure illustrated in Figs. 1 and 2. For example, the one superconductor 11 alone may be formed in a superposed structure (consisting of the first superconductive layer 16 possessing a large energy gap and positioned on the outer side and the second superconductive layer 17 having a small energy gap and positioned on the inner side, respectively relative to the tunnel barrier layer 13) and the other superconductor 12 in a single-layer structure as in the typical structure illustrated in Figs. 7, 8, and 10. Otherwise, both of the superconductors 11 and 12 may be formed each in a single layer structure as in the typical structure illustrated in Fig. 9. In the radiation sensing device of the first embodiment of this invention, it is exclusively through the thin-wall part 14 of the tunnel barrier layer 13 that the excited electrons are passed by virtue of the tunnel effect. When the superconductor 11 (or the superconductor 12) assumes such a laminated structure as described above, therefore, an extremely high trap effect is obtained even when the second superconductive layer 17 is formed only in the portion contiguous to the thin-wall part 14 as in the typical structure illustrated in Fig. 8.

Fig. 3 typically depicts the manner in which radiation or photon impinges on the radiation sensing device of the typical structure illustrated in Figs. 1 and 2. Since the thin-wall part 14 through which the passage of excited electrons is attained by virtue of the tunnel effect is distributed substantially uniformly throughout the entire tunnel barrier layer 13 and the nearest distance from a given position on the superconductor 11 to the thin-wall part 14 as described above, when the excited electrons 21 are produced by the absorption of radiation or photon 20 at any position of the first superconductive layer 16 of the superconductor 11, the time required by the excited electrons 21 in passing from the first superconductive layer 16 to the second superconductive layer 17 and eventually reaching the thin-wall part 14 by virtue of diffusion is amply short and uniform.

The materials which are usable for the formation of the superconductor 11 and the superconductor 12 in the first radiation sensing device of this invention specifically include aluminum, indium, tin, lead, tantalum, niobium, vanadium, Nb₃Sn, Nb₃Ge, Nb₃Al, Nb₃Ga, NbN, Nb₃Al_{0.75}Ge_{0.25}, Nb_{0.55}Ti_{0.45}, V₃Ga, V₃Si, Pb₁Mo_{5.1}S₆(SN)ₓ high polymer, and oxide superconductors.

The materials which are usable for the formation of the tunnel barrier layer 13 (the thin-wall part 14 and the thick-wall part 15) include the oxides of the superconductive materials enumerated above such as, for example, alumina, indium oxide, tin oxide, lead oxide, tantalum oxide, niobium oxide, and silica. Of course, insulators other than the oxides of the supercondutive materials are usable. Such semiconductors as Si, Ge, GaAs, and InSb are also usable.

The radiation sensing device of the first embodiment of this invention possessing the structure described above can be produced by thin-film forming techniques such as vacuum deposition, spattering, or the vapour-phase growth method and by lithographic techniques using the materials enumerated above. For example, this production is effected by forming a thin film of such a superconductive material as mentioned above by vacuum evaporation on a substrate, allowing the entire surface of the thin film to be spontaneously oxidised thereby forming an insulating layer destined to serve as a thin-wall part of a tunnel barrier layer, then optionally forming a thin film of a superconductive material destined to serve as a partial layer of a counter electrode by vacuum evaporation, subsequently forming a resist film by a lithographic technique, oxidised the portion not covered with the resist film by the anodic oxidation method thereby forming an insulating layer destined to serve as a thick-wall part of the tunnel barrier layer (an insulating layer formed by anodic oxidation extends amply below the insulating layer by spontaneous oxidation and the thin film of superconductive material destined to serve as a lower electrode is not oxidised throughout the entire thickness of the layer) thereby giving rise to a tunnel barrier layer consisting of a thin-wall part and a thick-wall part and possessing a desired pattern, removing the resist film, and thereafter forming a thin film of a superconductive material destined to serve as a partial layer of the counter electrode as by vacuum deposition. The method for the production of the radiation sensing device of this invention is not limited to the procedure just described. For the formation of the thin-wall part and the thick-wall part of the tunnel barrier layer, for example, the method which comprises forming a layer of an insulating material or a semiconductive material on the entire surface or through partial masking by a thin-film forming technique such as, for example, vacuum evaporation may be adopted.

The description so far given has pertained to a superconducting tunnel junction radiation sensing device of the superconductor-tunnel barrier-superconductor structure. When one of the superconductors of the superconducting tunnel junction is the main absorbent for radiation or photon, the other superconductor is intended solely for the extraction of excited electrons and, therefore, may be a semiconductor which possesses an energy gap similarly to a superconductor. Thus, the superconducting tunnel junction radiation sensing device of the first embodiment of this invention embraces devices which have a superconductor-tunnel barrier-semiconductor structure.

In yet another typical structure, the radiation sensing device of the first embodiment of this invention possesses a superconductor-tunnel barrier-semiconductor structure which, as illustrated in Fig. 11, has a tunnel barrier layer 13 disposed throughout the entire junction between the superconductor 11 destined to serve as a lower electrode and a semiconductor 22 destined to serves as a counter electrode. The tunnel barrier layer 13, similarly to the countertype in the aforementioned device of the superconductor-tunnel barrier-superconductor structure, is composed of a thin-wall part 14 made of a thin insulator or semicondcutor and a thick-wall part 15 made of a thick insulator or semiconductor. The relation between the thin-wall part 14 and the thick-wall part 15 with respect to thickness and disposition is similar to that which has been described above with respect to the device of the superconductor-tunnel barrier-superconductor structure.

In the device of the superconductor-tunnel barrier-semiconductor structure, too, from the standpoint of enhancing the efficiency of collection of excited electrons in the thin-wall part of the tunnel barrier layer owing to the trap effect, the superconductor disposed on one side of the tunnel barrier layer may be composed of two or more superconductive layers of different magnitudes of energy gap which are superposed in such a manner that the the superconductive layer is to the tunnel barrier layer, the smaller is the magnitude of energy gap of the superconductive layer. In the typical structure illustrated in Fig. 11, for example, the superconductor 11 comprises the first superconductive layer 16 on the outer side and the second superconductive layer 17 possessing a smaller energy gas than the first superconductive layer 16 located on the inner side, respectively relative to the tunnel barrier layer 13. Incidentally, the semiconductor disposed on the other side of the tunnel barrier may be composed of two or more semiconductive layers of different magnitudes of energy gap, in the same manner as described above.

In the radiation sensing device contemplated by the first embodiment of this invention and possessing the superconductor-tunnel barrier-semiconductor structure described above, the materials which are usable for the formation of the superconductor 11 and the tunnel barrier layer 13 (consisting of the thin-wall part 14 and the thick-wall part 15) are the same as those for the countertypes in the radiation sensing device of the superconductor-tunnel barrier-superconductor structure described above. The materials which are usable for the formation of the semiconductor 12 specifically include Si, Ge, GaAs, and InSb, for example. The method to be employed for the production of the radiation sensing device of this structure is the same as described above.

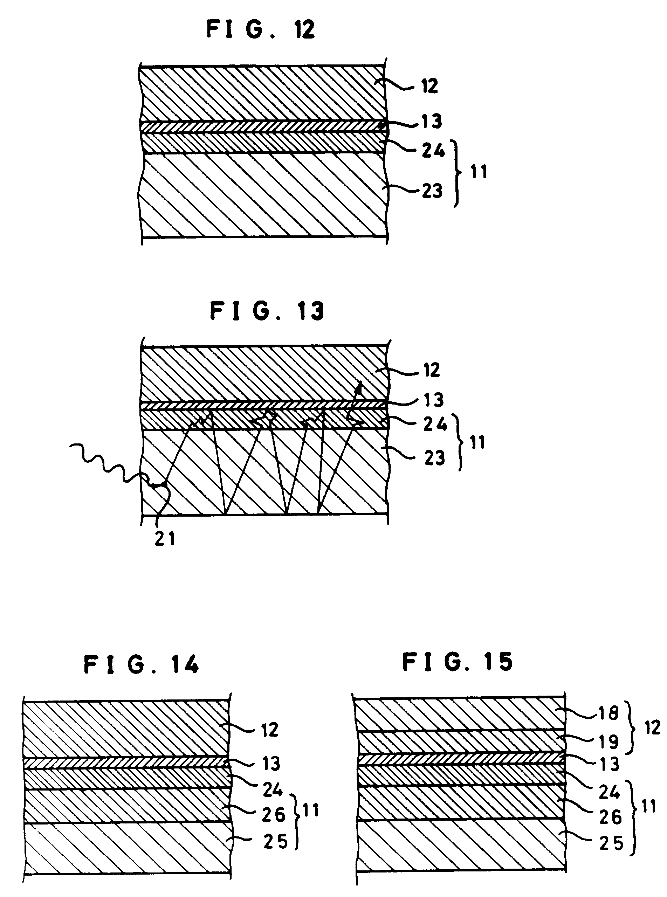

Fig. 12 is a cross section illustrating a typical structure of a radiation sensing device according to and second embodiment of this invention.

The radiation sensing device illustrated in Fig. 12 possesses a superconductor-tunnel barrier-superconductor structure having the tunnel barrier layer 13 disposed throughout the entire junction between the lower superconductor 11 and the upper superconductor 12. The lower superconductor 12 is composed of a single-crystal superconductive layer 23 and a polycrystalline superconductive layer 24 superposed on the layer 23. The tunnel barrier layer 13, therefore, is formed on the polycrystalline superconductive layer 24.

In the radiation sensing device contemplated as the second embodiment of this invention and possessing the structure described above, the thickness of the polycrystalline superconductive layer 24 is required to be not more than one half, preferably not more than one tenth, of that of the single-crystal superconductive layer 23. The reason for this particular upper limit of thickness is that even when the thickness of the polycrystalline superconductive layer 24 increases past the level specified or the thickness of the single-crystal superconductive layer 23 decreases below the level, the efficiency of collection of excited electrons as signal charges cannot be expected to increase .

Fig. 13 typically illustrates the manner in which the radiation or photon 20 impinges on the radiation sensing device of the typical structure illustrated in Fig. 12. It is believed that since the portion in which the excited electrons 21 are generated by the impingement of the radiation or photon 20 is formed of the single-crystal superconductive layer 23 as described above and the polycrystalline superconductive layer 24 deposited on the superconductive layer 23 has a small wall thickness, the average time required for completion of the tunnelling of the excited electrons 21 is shortened and the probability of the excited electrons 21 being taken out as signals is improved in great measure.

Further, the radiation sensing device of the second embodiment of this invention appreciably restrains the otherwise possible occurrence of leak current because the tunnel barrier layer 13 is not formed directly on the single-crystal superconductive layer 23 but is superposed on the polycrystalline superconductive layer 24 which has been already formed on the single-crystal superconductive layer 23.

To be more specific, the device having a tunnel junction formed by superposing the tunnel barrier layer 113 and the upper superconductive layer 112 directly on the single-crystal superconductor 131 as described above (Fig. 28) has a too large leak current to be effectively applied to a radiation sensing device of high resolution. The present inventors conducted a diligent study with a view to elucidating the cause for this large leak current. The following conclusion has consequently been drawn. When a tunnel barrier layer 113 of a very small thickness (generally not more than 10 nm) is formed as by vacuum evaporation on the polycrystalline superconductor 111 as illustrated in Fig. 29, the atoms or molecules which have reached the upper side of the superconductor 111 do not appreciably move around on the surface of the polycrystalline superconductor 111 but are immediately fixed thereon to give rise to a uniform film because numerous grain boundaries 130 are present in the polycrystalline superconductor 111. Of course, this phenomenon depends on the combination of the substance of the superconductor 111 and the substance of the tunnel barrier layer 113. When the tunnel junction is formed by superposing the tunnel barrier layer on the polycrystalline superconductor as described above, the produced junction structure tends to acquire the desirable quality of betraying only a small leak current. It is considered, however, that once the formation of the tunnel barrier layer 113 on the single-crystal superconductor 131 begins to take place, since the surface of the superconductor 131 is flat and smooth on the scale of the size of atoms, the atoms and molecules landing on the surface are liable to move around on the surface and first attain growth in the form of islands and that these islands eventually grow in the form of a film as the amount of atoms and molecules adhering to the surface increases and the film assumes an uneven texture and abounds with pinholes. In this case, therefore, the formation of the junction tends to entail an addition to the leak current.

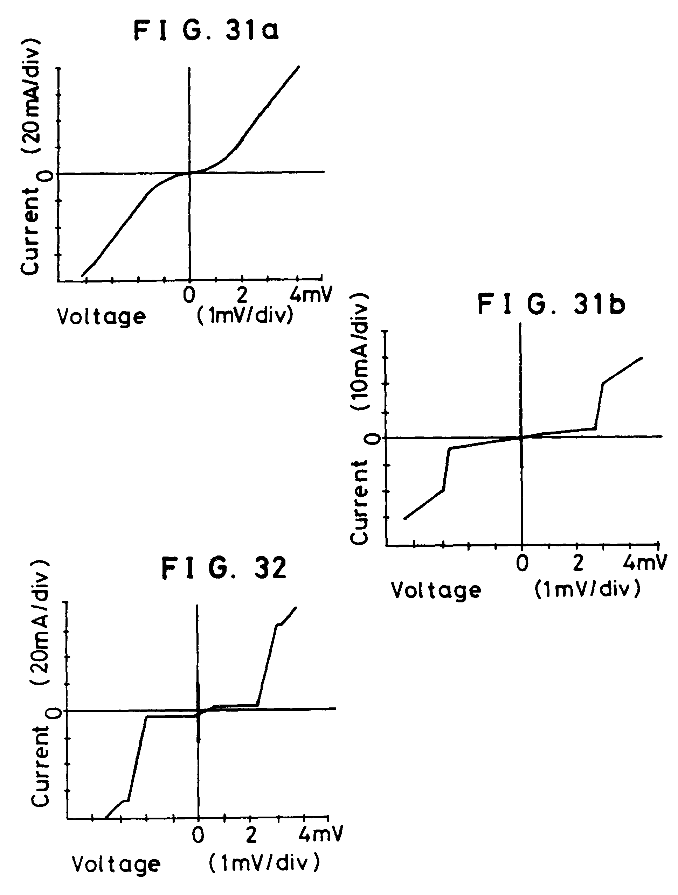

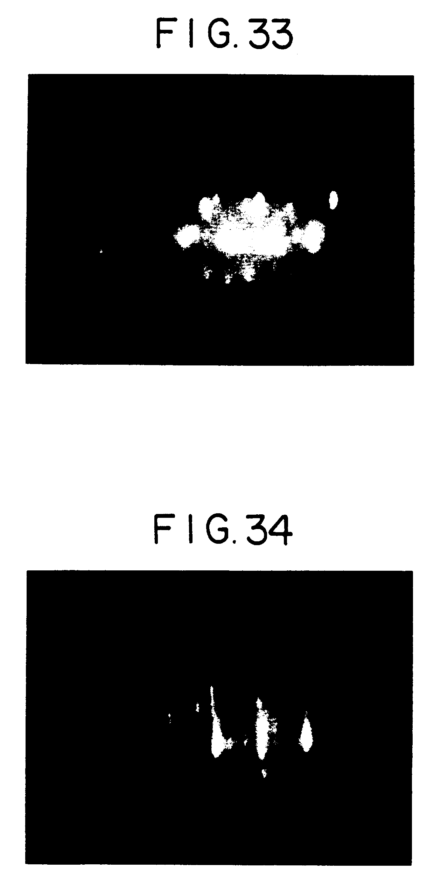

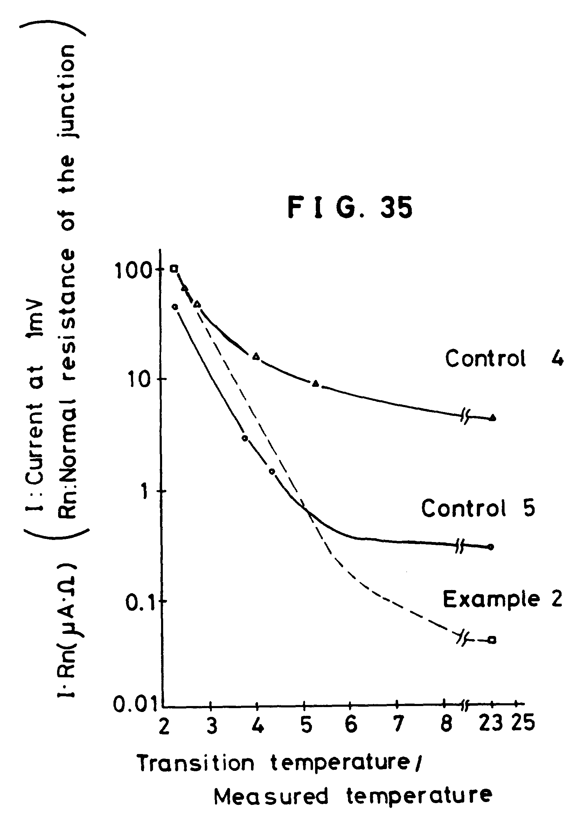

With reference to the data obtained in an experiment which will be described specifically hereinafter, the reflection high-energy electron diffraction (RHEED) image (Fig. 33) of a film of Al vacuum evaporated in a thickness of about 10 nm on a single-crystal Nb film showed a single-crystal pattern of rough surface clearly different from an annular pattern appearing in the RHEED of a film of A1 vacuum evaporated on the ordinary polycrystalline Nb film. This fact indicates that Al has grown into crystals in the form of islands or the underlying single crystals of Nb have not been completely covered by the grown crystals of Al. By this reason, the leak current in the junction produced by superposing a Nb film on a layer of spontaneously oxidised Al is evidently inferior to that in the junction using the ordinary polycrystalline superconductor (Figs. 31a and 31b). In contrast, in the device of the structure contemplated by the second embodiment of this invention which is produced by forming a thin polycrystalline Nb film on a single-crystal Nb film, vacuum evaporating Al thereon, then oxidising the Al surface thereby giving rise to a tunnel barrier layer, and further superposing a Nb film thereon as an upper superconductor, the leak current is extremely small and favorably comparable with that of the conventional device using only polycrystalline superconductors (Fig. 32 and Fig. 35). The device used in this case is produced by using superconductors made of Nb and a tunnel barrier layer made of A1 with oxidised surface. It is plain that the structure of the second embodiment of this invention can be extensively applied to various other combinations. When a tunnel barrier layer exhibiting bad lattice matching to a single-crystal substrate is to be formed in a thickness of not more than 10 nm on the substrate, since the film generally tends to grow in the form of island and form an uneven texture, the tunnel barrier layer incorporated in a tunnel junction is liable to entail a large leak current. In this respect, the second embodiment of this invention is only required to form a tunnel junction by forming on a single-crystal superconductor of a substance different from the substance of a tunnel barrier layer a film of a polycrystalline superconductor capable of growing a film (which may be of the same substance as the single-crystal superconductor) and superposing the tunnel barrier layer thereon.

For the radiation sensing device of the second embodiment of this invention, the structure of the upper superconductor 12 is not critical. While it suffices to form the upper superconductor 12 with a superconductor, it is naturally permissible to produce this upper superconductor 12 in a structure such that, similarly to the lower superconductor 11, a polycrystalline superconductive layer of a small thickness is disposed on the side exposed to the tunnel barrier layer 13 and the single-crystal superconductive layer is superposed thereon.

Fig. 14 and Fig. 15 represent other typical structures of the radiation sensing device of the second embodiment of this invention. In each of these structures, for the purpose of enhancing the effect of trapping of excited electrons, the lower superconductor 11 is composed of a first single-crystal superconductive layer 25, a second single-crystal superconductive layer 26 having a smaller energy gap than the first single-crystal superconductor 25, and a polycrystalline superconductive layer 24, severally disposed in the order of decreasing distance from the tunnel barrier layer 13 and the upper superconductor 12 is composed of a first superconductive layer 18 on the outer side and a second superconductive layer 19 having a smaller energy gap located on the inner side, respectively relative to the tunnel barrier layer 13.

The radiation sensing device of the second embodiment of this invention, similarly to the radiation sensing device of the first embodiment described above, embraces the superconductor-tunnel barrier-semiconductor structure (not shown).

The radiation sensing device of the second embodiment of this invention possessing this structure can be produced by employing a thin film forming technique such as the vacuum evaporation method, the sputtering method, or the vapour phase growth method using the same material as specifically mentioned in the foregoing description of the first embodiment. This production, for example, may be accomplished by forming on a substrate a single-crystal superconductor of the aforementioned description as by vacuum evaporation, then superposing thereon a thin film of polycrystalline superconductor by vacuum evaporation or spattering, subsequently depositing on the polycrystalline superconductor thin film a substance destined to form a tunnel barrier layer similarly by vacuum evaporation or spattering, allowing the entire surface of the deposited layer to undergo spontaneous oxidation and give rise to an insulating layer, and thereafter forming an upper superconductive layer as by vacuum evaporation. The method for the production of the radiation sensing device of the second embodiment of this invention is not limited to the procedure described above.

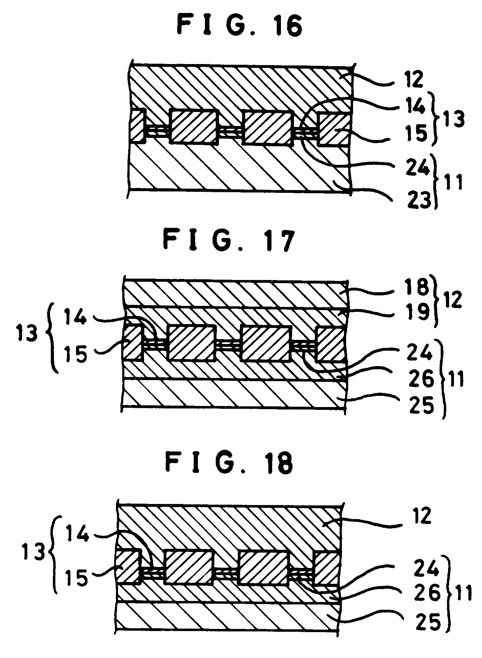

Fig. 16 is a cross section illustrating a typical structure of the radiation sensing device as the third embodiment of this invention.

The radiation sensing device illustrated in Fig. 16 possesses a superconductor-tunnel barrier-superconductor structure having a tunnel barrier layer 13 disposed throughout the entire junction between a superconductor 11 destined to form a lower electrode and a superconductor 12 destined to form a counter electrode. This tunnel barrier layer 13 is composed of a thin-wall part 14 made of a thin insulator or semiconductor and a thick-wall part 15 made of a thick insulator or semiconductor. The lower superconductor 11 is composed of a single-crystal superconductive layer 23 and a polycrystalline superconductive layer 24 superposed thereon. The tunnel barrier layer 13 (at least the thin-wall part 14 thereof) is formed on the polycrystalline superconductive layer 24.

In the radiation sensing device of the third embodiment of this invention, the relation between the thin-wall part 14 and the thick-wall part 15 of the tunnel barrier layer 13 in terms of thickness and disposition is the same as that described above with respect to the radiation sensing device of the first embodiment of this invention. In the radiation sensing device of this third embodiment, the relation between the single-crystal superconductive layer 23 and the polycrystalline superconductive layer 24 of the lower superconductor 11 in terms of thickness and the like is the same as that described above with respect to the radiation sensing device of the second embodiment of this invention.

Further, in the radiation sensing device of the third embodiment, the portion in which the polycrystalline superconductive layer 24 of the lower superconductor 12 is formed is only required to include the portion in which the superconductive layer 24 adjoins at least the thin-wall part 14 of the tunnel barrier layer 13 as described above. The reason for this condition is that any structural defect of film liable to form a cause for a leak current does not not readily occur in the thick-wall part 15 possessing an ample thickness even when the tunnel barrier layer 13 is made of a substance exhibiting bad lattice matching to the single-crsytal superconductive layer 24.

Fig. 17 and Fig. 18 represent other typical structures of the radiation sensing device of the third embodiment. In each of the structures, for the purpose of enhancing the effect of trapping of excited electrons, the lower superconductor 11 is composed of a first single-crystal superconductive layer 25, a second single-crystal superconductive layer 26 having a smaller energy gap than the first single-crystal superconductive layer 25, and a polycrystalline superconductive layer 24, severally disposed in order of decreasing distance from the tunnel barrier layer 13 and the upper superconductor 12 is composed of a first superconductive layer 18 on the outer side and a second sueprconductive layer 19 having a smaller energy gap located on the inner side, both relative to the tunnel barrier layer 13.

The radiation sensing device of the third embodiment of this invention, similarly to the radiation sensing device of the first embodiment described above, embraces a radiation sensing device possessing a superconductor-tunnel barrier-semiconductor structure (not shown).

The radiation sensing device of the third embodiment of this invention possessing this structure manifests truly prominent characteristics owing to the synergism between the structural merits of the first and second embodiments mentioned above. Since the portion in which excited electrons are produced by the impingement of radiation or photon is formed of the single-crystal superconductive layer and the polycrystalline superconductive layer superposed thereon is thin, the excited electrons have a long mean free path in the single-crystal superconductor. Because of this fact, the average time required in completing the tunnelling is shortened. Further since the thin-wall part through which the excited electrons are enabled to pass by virtue of the tunnel effect is substantially uniformly distributed throughout the entire tunnel barrier layer and the shortest distance from a given position on the lower superconductor to the thin-wall part falls within a fixed range, the time required by the excited electrons in reaching the thin-wall part by virtue of diffusion is amply short and uniform, no matter where the electrons are excited in the single-crystal superconductive layer of the lower superconductor. Consequently, the probability with which the excited electrons are taken out as signals is enhanced in large measure and the variations in rise time and pulse height of signals due to the position of impingement are restricted to small values. Moreover, at least the thin-wall part of the tunnel barrier layer possesses a uniform structure and generates leak current only sparingly because it is not formed on the single-crystal superconductive layer but on the thin-wall polycrystalline superconductive layer superposed on the single-crystal superconductive layer.

The radiation sensing device of the third embodiment of this invention possessing this structure can be produced by employing a thin-film forming technique such as the vacuum evaporation method, the sputtering method, or the vapour-phase growth method and a lithographic technique, using the same material as specifically cited in the foregoing description with respect to the radiation sensing device of the first embodiment. This production is effected, for example, by forming on a substrate a single-crystal superconductive layer as by vacuum evaporation, then superposing on the single-crystal superconductive layer a thin film of polycrystalline superconductor as by vacuum evaporation or spattering, depositing thereon a material capable of forming a thin-wall part of the tunnel barrier layer likewise by vacuum evaporation or spattering, allowing the deposited layer of the material to undergo spontaneous oxidation and give rise to an insulating layer destined to serve as a thin-wall part of the tunnel barrier layer, then optionally forming a layer of a superconductive material destined to form a partial layer of a counter electrode as by vacuum evaporation, then, forming a resist film by a lithographic technique, allowing the portion not covered with the resist film to be oxidised by the anodic oxidation method thereby forming an insulating layer destined to serve as a thick-wall part of the tunnel barrier layer (the insulating layer by this anodic oxidation extends amply below the insulating layer by the spontaneous oxidation mentioned above and the superconductive material destined to form the lower electrode is not oxidized throughout the entire thickness of the layer) and consequently giving rise to a tunnel barrier layer consisting of a thin-wall part and a thick-wall part and possessing a desired pattern, removing the resist film, and further forming a thin film of a superconductive material destined to form a partial layer of the counter electrode as by vacuum evaporation. The method for the production of the radiation sensing device of the third embodiment of this invention is not limited to the procedure described above.

The junction structure in the Josephson device of the fourth embodiment of this invention is substantially identical to that in the radiation sensing device of the second embodiment of this invention.

Specifically, the Josephson device of the fourth embodiment of this invention possesses a superconductor-tunnel barrier-superconductor structure having a tunnel barrier layer 13 disposed throughout the entire junction between a lower superconductor 11 and an upper superconductor 12 as illustrated in Fig. 12. In this structure, the lower superconductor 12 is composed of a single-crystal superconductive layer 23 and a polycrystalline superconductive layer 24 and, therefore, the tunnel barrier layer 13 is formed on the polycrystaslline superconductive layer 24.

In the Josephson device of the fourth embodiment of this invention possessing this structure, the single-crystal superconductive layer 23 is required to have a thickness exceeding the magnetic penetration length in order that it may shield a magnetic field.

In the Josephson device of the fourth embodiment of this invention, since the possibility of the device generating leak current is curbed in a great measure for the same reason as given above in the foregoing description of the radiation sensing device of the second embodiment, the Josephson device to be produced imposes a marked restraint on the occurrence of a magnetic flux trap by virtue of the single-crystal superconductor and shows a very good performance.

### EXAMPLES

For more specific illustration of the present invention, the following examples are presented which are intended to be merely illustrative of and not in any sense limitative of the invention.

### Experiment 1: Discussion on device's response speed

To produce a device contemplated by the first embodiment of this invention (Example), a Nb film 42 having a thickness of 500 nm (5,000 Å) was deposited as a first superconductive layer of a lower superconductor on a glass substrate 41, an Al film 43 having a thickness of 50 nm (500 Å) was further superposed thereon as a trapping superconductive layer by spattering, then the surface of the Al film 43 was spontaneously oxidised at room temperature in a vacuum device under introduction of oxygen gas thereby giving rise to an AlOₓ film 44 having a thickness of 2 to 3 nm (20 to 30 Å) and destined to serve as a tunnel barrier (thin-wall layer), and further continuously superposing thereon an Al film 45 having a thickness of 50 nm (500 Å) and destined to serve as a trapping superconductive layer and a Nb film 46 having a thickness of 20 nm (200 Å) by sputtering.

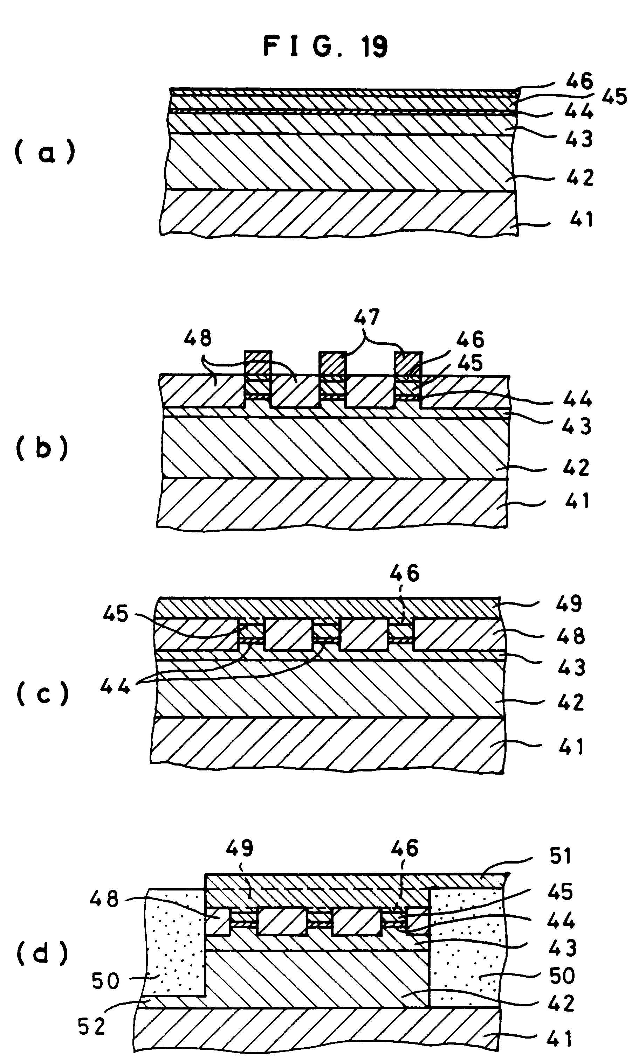

Then, an anodically oxidised layer 48 destined to form a thick-wall part of a tunnel barrier layer was produced as illustrated in Fig. 19b by forming a resist film 47 by the lithographic technique so as to cover only the portion in which the thin-wall part of the tunnel barrier layer was desired to be formed and subjecting the portion not covered with the resist film 47 to anodic oxidation. The anodically oxidised film 48 was produced with due care taken so that the film would grow amply below the AlOₓ film 48 and the Al film 43 would not be wholly oxidised.

Subsequently, the resist film was removed, the surface was cleaned by Ar spattering in a vacuum device, and a Nb film 49 having a thickness of 100 nm (1000 Å) was formed by vacuum evaporation on the upper surface of the laminated structure as illustrated in Fig. 19c.

Finally, the resultant laminate composite was fabricated by lithography and reactive ion etching into a device structure as illustrated in Fig. 19d and a Nb film 51 for upper wiring was deposited thereon by vacuum evaporation.

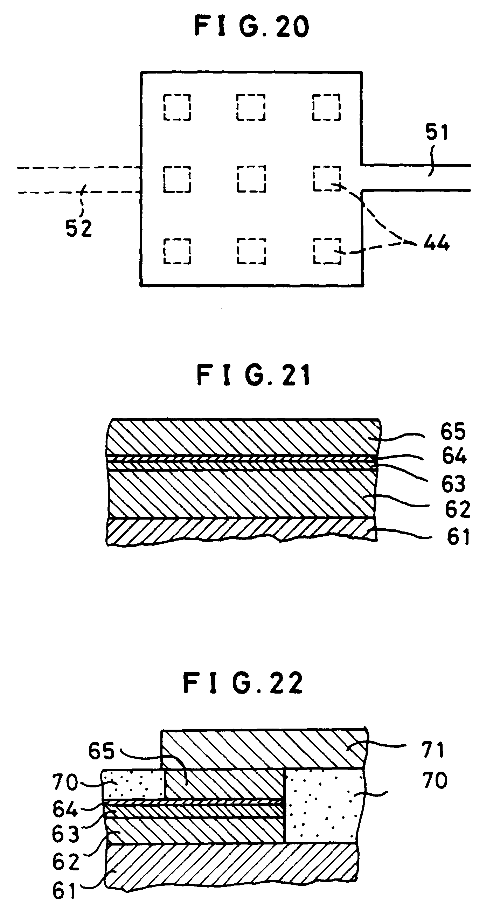

Fig. 20 is a plan view illustrating the device thus produced. In this device, the part of the AlOₓ film 44 remaining as the thin-wall part consisted of nine component pieces distributed uniformly throughout the entire device. These component pieces each had a surface area of 0.0009 mm. The total surface area of the device (excluding the upper wiring 51 and the lower wiring 52) was 0.0729 mm.

The thickness of the anodically oxidised film 48 portion was about 100 nm (1,000 Å) and the thickness of the AlOx film 44 portion was 2 to 3 nm (20 to 30 Å). Since the electrostatic capacity of a film of this kind per unit surface area is inversely proportional to the thickness of film, the electrostatic capacity of the device was substantially determined exclusively by the AlOₓ film 44 portion destined to serve as a thin-wall part and possessing a total surface area of 0.0081 mm, though the surface area 0.0648 mm of the anodically oxidised film 48 portion accounted for 89% of the total surface area of the sensing device.

In the case of a device having a total surface area of device was 0.0729 mm (square of 0.27 mm) and containing an AlOₓ film portion destined to serve as a thin-wall part and possessing a total surface area of 0.081 mm and constituting itself one inseparate square piece located at the centre of the device (hereinafter referred to as "device of Control 1"), the electrons or electron holes excited in the corners of the device must be diffused over a linear distance of at least 126 pm in reaching the thin-wall part of the tunnel barrier layer. In contrast, in the device of Example 1, even the electrons or electron holes excited in the corners of the device must be diffused over a linear distance of 42 µm. Since the length of diffusion barely increases in proportion to the 0.5th power of the time, this three-times difference in length of diffusion brings about an extremely large difference concerning the response speed of the device and the rise time and the magnitude of signal due to the position of incidence of radiation or photon.

Actually to find this difference, the device of Example 1 and the device of Control 1 mentioned above were uniformly exposed in their whole surfaces to a pulse laser beam (pulse width 200 ns) and the responses of these devices were compared. It was consequently found that the rise time of signal was 400 ns in the device of Example 1 as compared with 600 ns in the device of Control 1. The fact that the ratio of rise time of signal between the two devices was about 1.5 : 1 may be logically explained by a supposition that the pulse width itself of the pulse laser beam used for the exposure was as large as 200 ns and the signals were produced by the average diffusion of the electrons or electron holes excited in the corners of device and the electrons or electron holes excited in the central part of device because the entire surfaces of the devices were uniformly exposed to the pulse beam. It is surmised that this ratio of rise time exclusively of the signals due to the electrons or electron holes excited in the corners of device would be much larger.

The magnitude of the peak of signals in the device of Example 1 detected in the experiment, reflecting the condition that the proportion of excited electrons and electron holes caused to recombine during the course of the rise of signal increases in proportion to the rise time being lengthened, was about 1.3 times that in the device of Control 1. Concerning the magnitude of signals, it is naturally expected that the ratio of the size exclusively of the signals due to the electrons or electron holes excited in the corners of device would be much larger.

By the present experiment, it has been demonstrated that a radiation sensing device possessing the structure of this invention possesses outstanding characteristics. It has been further established that even when the total surface area of the thin-wall part serving as a substantial tunnel barrier is fixed, more desirable results are obtained by decreasing the surface area of each of the component pieces of the thin-wall part, increasing the number of such component pieces, and having the component pieces uniformly distributed throughout the entire device.

### Experiment 2: Discussion on leak current in device (1)

A device contemplated by the second embodiment of this invention (Example 2) was produced as follows.

A single-crystal sapphire of a (1102) plane was used as a substrate 61. This substrate 61 was placed in an ultrahigh vacuum evaporation device haivng an attainable vacuum degree of about 133 . 10⁻¹⁰ Pa (1 x 10⁻¹⁰ Torr) and heated to about 700°C with a heater disposed behind the substrate 61. An ingot of Nb was placed in a water-cooled copper crucible and heated by exposing the surface thereof to an electron beam to effect vacuum evaporation of Nb. The Nb film 62 consequently deposited on the sapphire substrate 61 grew into a single-crystal film as evinced by a reflection high-energy electron diffraction (RHEED) image shown in Fig. 34. This film had a thickness of about 600 nm.

Then, the resultant composite was taken out of the vacuum evaporation device and set in place in a sputtering device provided with Nb and Al sputtering targets. Inside the sputtering device, the composite (substrate) was kept cooled with water near room temperature (about 20°C ± 10°C). In the sputtering device, the surface of the Nb film 62 was etched to a depth of about 3 nm by reverse sputtering with Ar so as to give a clean surface to the Nb film 62. Then, on the composite, a Nb film 63 about 20 nm in thickness and an Al film about 10 nm were superposed by sputtering. Subsequently, in the sputtering device, the surface of the Al film was spontaneously oxidised with an oxygen gas of about 133 Pa (1 Torr) introduced into the device to give rise to an AlOₓ-Al film 64. Further thereon, a polycrystalline Nb film 65 about 200 nm in thickness was superposed as an upper superconductor by spattering. This condition of stratification is depicted in Fig. 21.

A device configured as illustrated in Fig. 22 was produced by subjecting the product resulting from the aforementioned superposition effected on the entire surface of the Sapphire substrate to fine processing by the SNIP (Self-aligned Niobium Isolation Process). The Nb film for upper wiring 71 was also superposed by sputtering. The lower wiring was formed by processing a single-crystal Nb film. The width of wire was 20 µm. The area of junction was 80 µm x 80 µm. In Fig. 22, the reference numeral 70 denotes a SiO₂ film intended as an interlayer insulating layer.

For comparison, two devices (Controls 2 and 3) were produced as follows.

In the production of the device of Control 2, a single-crystal Nb film was formed first in the same manner as in Example 2 and an Al film about 10 nm in thickness was directly superposed thereon by sputtering following after reverse sputter cleaning with Ar, without forming a polycrystalline Nb film thereon in the meantime. Then, after the pattern of Example 2, the resultant composite was placed in a sputtering device, the surface of the Al film was spontaneously oxidised by introducing an oxygen gas of about 1 Torr in the device, and a Nb film about 200 nm in thickness was deposited thereon as an upper superconductor by sputtering. The resultant product of superposition was subjected to fine processing by the SNIP method to produce the device.

In the production of the device of Control 3, a single-crystal Nb film was formed in the same manner as in Example 2 and an Al film about 10 nm in thickness was directly superposed thereon by vacuum evaporation in the same vacuum evaportion apparatus without forming a polycrystalline Nb film thereon in the meantime. A RHEED of the composite obtained by vacuum evaporating an Al film on this single-crystal Nb film is shown in Fig. 33. Subsequently, the surface of the Al film was spontaneously oxidised and a Nb film about 200 nm in thickness was superposed thereon as an upper superconductor by vacuum evaporation. The resultant composite was finely processed by the SNIP method to produce the device.

The devices of Example 2 and Controls 2 and 3 obtained as described above were tested for current-voltage characteristics at 4.2 K. The results are shown in Fig. 32 and Figs. 31a and b.

It is clearly noted from Figs. 31a and b that in the devices of Controls 2 and 3 having a tunnel barrier layer superposed directly on a single-crystal superconductor, the current at a voltage of not more than about 2 mV was so large as to entail a large leak current. These characteristics evidently are inferior to those of the devices using an ordinary polycrystalline superconductor. In contrast, in the device of example 2, the leak current discernible at 4.2 K was equivalent to or lower than that of the device using only the conventional polycrystalline Nb.

### Experiment 3: Discussion on leak current in device (2)

For more deliberate study of the leak current, it is advantageous to lower the temperature of the sample. This is because the electric current which is caused to flow by the tunnel effect of the thermally excited electrons is decreased by lowering the temperature, whereas the leak current does not depend on temperature.

Actually, the device of Example 2 described above was tested for temperature dependence of the magnitude of electric current at 1 mV. The results are shown in Fig. 35.

As conventional devices to be used for comparison, a device (Control 4) in a polycrystalline Nb film-AlOₓ film-polycrystalline Nb film structure was produced by the SNIP method and a device (Control 5) of a polycrystalline Nb film-AlOₓ film-polycrystalline Nb film structure was produced by the SNEP (selective niobium etching process). These devices were similarly tested for temperature dependence of the magnitude of electric current at 1 mV. The results are shown in Fig. 35. In the devices of Control 4 and Control 5, the Nb films had a thickness of about 200 nm and the AlOₓ films had a thickness of about 2 - 3 nm.

It was found consequently that the leak current in the device of Example 2 conforming to this invention was considerably smaller than that of the device of Control 4 as found in Fig. 35 and was equal to or smaller than that of the device of Control 5 produced by the SNEP method resorting to anodic oxidation capable of decreasing the leak current at the end of junction. These results may be logically explained by the supposition that in the device of Example 2, since the surface of the single-crystal Nb film was covered with a thin polycrystalline Nb film, the Al film formed thereon did not grow in the form of islands and that the single-crystal Nb film epitaxially grown on the Sapphire substrate possessed so high a mechanical strength as to preclude ready occurrence of defects on the inner surface of the tunnel barrier or in the end parts of the tunnel barrier during the course of fine moulding.

Incidentally, in the devices of Controls 2 and 3 described above having a tunnel barrier layer directly superposed on a single-crystal superconductor (not shown), the magnitudes of current were lowered only sparingly when the temperature was lowered in the manner described above. This fact supports the results of Experiment 2.

### Experiment 4: Discussion on radiation sensing capacity in device

For direct study of the influence of this invention on the performance of a radiation sensing device, the device of Example 2 which had undergone the treatment of the SNIP method, the device of Control 4 which had similarly undergone the treatment of the SNIP method, and the device of Control 5 which had undergone the treatment of the SNEP method were severally exposed to an X-ray of about 5.9 KeV and the signals consequently issued from the devices were dispersed into pulse-height spectra. During the experiment, the devices were invariably cooled to 0.4 K.

In the device of Control 4, i.e. a conventional device which had undergone the treatment of the SNIP method, no discernible signal was found even when the surface area of device was decreased to 20 µm x 20 µm for the purpose of decreasing the leak current. The signal by the X-ray, if generated, was smaller than the noise and, therefore, could not be discriminated from the noise.

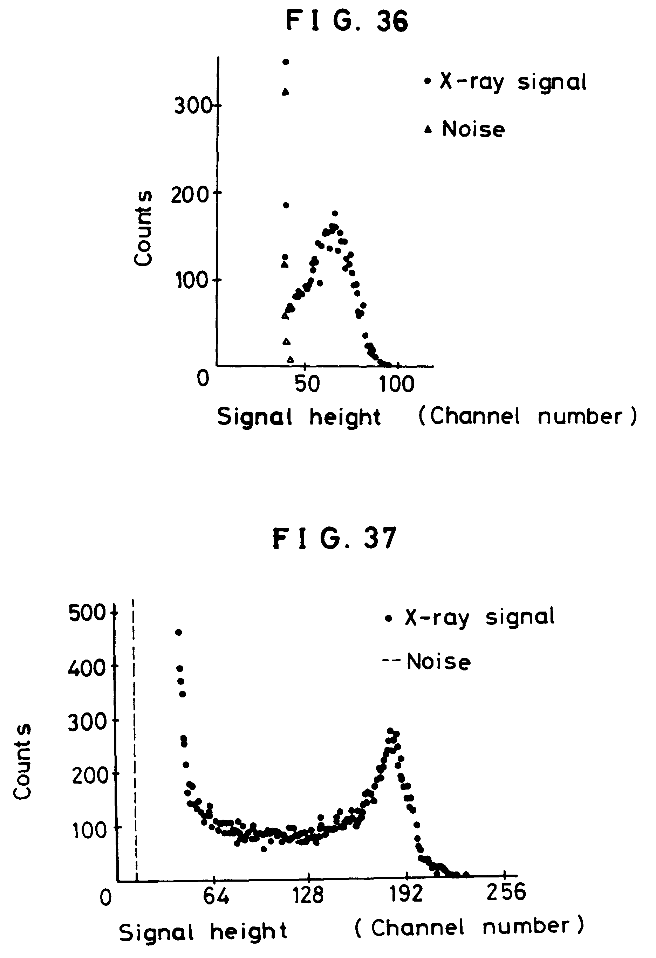

In the device of Control 5, i.e. a conventional device which had undergone the treatment of the SNEP method, when the surface area of device was 20 µm x 20 µm, the signal due to the X-ray could be discriminated from the noise. This improvement in signal may be logically explained by the assumption that the leak current in this device was smaller than that in the conventional device which had undergone the treatment of the SNIP method as shown in Fig. 35. The pulse-height spectrum is shown in Fig. 36. The magnitude of electric charge of the signal by the X-ray, namely the magnitude of signal corresponding to the peak of the pulse-height spectrum, was as large as about 10 times that of the conventional semiconductor radiation sensing device using Si or Ge. The electric charge thus taken out in the form of signals was still as small as about one-hundredth of the theoretically estimated magnitude of excited electrons generated in Nb by the X-ray, indicating that the excited electrons were not efficiently taken out as signal charge.

In contrast, in the device of Example 2 conforming to the present invention, a pulse-height spectrum shown in Fig. 37 was obtained when the surface area of device was 80 µm x 80 µm. Since the amplification ratios of the signal amplifiers used were different, like channel numbers do not correspond to like signal sizes between the horizontal axis of Fig. 36 and the horizontal axis of Fig. 37. In both of the spectra, the values of peak along the horizontal axes equalled 5.9 keV. Fig. 37 shows evidently better S/N ratios (ratio of signal size/noise size) than Fig. 36. In the case of the spectrum of Fig. 37, the magnitude of electric charge of signal by the X-ray was 150 to 180 times that of the conventional semiconductor radiation sensing device using Si or Ge and about 20 times that of the conventional device which had undergone the treatment of the SNEP method.

## Claims

1. A superconducting tunnel junction radiation sensing device comprising a superconductor-tunnel barrier-superconductor structure, the radiation sensing device being characterised in that part of the tunnel barrier layer (13) is formed of a thin-wall part (14) made of an insulator 0.5 to 10 nm (5 to 100 Å) in thickness or a semiconductor 0.5 to 100 nm (5 to 1,000 Å) in thickness, and the other part of the barrier layer (13) is formed of a thick-wall part (15) made of an insulator or a semiconductor having a thickness at least twice as great as that of the thin-wall part; the thin-wall part being uniformly distributed discontinuously or continuously throughout the entire tunnel barrier layer (13); and the thin-wall part (14) having a smaller total surface area than the thick-wall part (15).

2. A radiation sensing device as claimed in Claim 1, characterised in that either or both of the superconductors (11,12) disposed on both sides of the tunnel barrier layer are each formed by superposing two or more superconductive layers (16,17,18,19) of different magnitudes of energy gap in such a manner that the closer the superconductive layer is to the tunnel barrier layer, the smaller is the magnitude of energy gap of the superconductive layer.

3. A superconducting tunnel junction radiation sensing device comprising a superconductor-tunnel barrier-semiconductor structure, the radiation sensing device being characterised in that part of the tunnel barrier layer (13) is formed of a thin-wall part (14) made of an insulator 0.5 to 10 nm (5 to 100 Å) in thickness or a semiconductor 0.5 to 100 nm (5 to 1,000 A) in thickness, and the other part of the barrier layer (13) is formed of a thick-wall part (15) made of an insulator or a semiconductor having a thickness at least twice as great as that of the thin-wall part; the thin-wall part being uniformly distributed discontinuously or continuously throughout the entire tunnel barrier layer (13); and the thin-wall part (14) having a smaller total surface area than the thick-wall part (15).

4. A radiation sensing device as claimed in Claim 3, characterised in that the superconductor (11) disposed on the one side of the tunnel barrier layer is formed by superposing two or more superconductive layers (16,17) of different magnitudes of energy gap in such manner that the closer the superconductive layer is to the tunnel barrier layer (13), the smaller is the magnitude of energy gap of the superconductive layer (11).

5. A radiation sensing device as claimed in any preceding Claim, characterised in that the, or one of the superconductive layer(s) (11) is formed of a single-crystal superconductive layer (23); a polycrystalline superconductive layer (24) having a thickness not more than one half of the thickness of the single-crystal superconductive layer (23) is formed on the single-crystal superconductive layer (23) in the portion continuous to at least the thin-wall part (14) of the tunnel barrier layer and the polycrystalline superconductive layer (24) adjoins the tunnel barrier layer (13).

6. A radiation sensing device as claimed in Claim 5, characterised in that the single-crystal superconductive layer (23) is formed by superposing two or more single-crystal superconductive layers (25,26) of different magnitudes of energy gap in such manner that the closer the single-crystal superconductive layer is to the tunnel barrier layer (13), the smaller is the magnitude of energy gap of the superconductive layer (11).

7. A radiation sensing device as claimed in any preceding Claim, characterised in that the thin-wall part of the tunnel barrier layer (14) is made of an insulator 0.5 to 3 nm (5 to 30Å) in thickness or a semiconductor 1 to 10 nm (10 to 100 Å) in thickness and the thick-wall part of the tunnel barrier layer (15) is made of an insulator or a semiconductor having a thickness of not less than five times the thickness of the thin-wall part (14).

8. A radiation sensing device as claimed in any preceding Claim, characterised in that the condition of the following expression is satisfied:$\text{0 < ℓ < (} \sqrt{\text{S}} \text{-} \sqrt{{\text{S}}_{\text{1}}} \text{)/} \sqrt{\text{π}}$ wherein S stands for the total surface area of the tunnel barrier layer; S₁ stands for the total surface area of the thin-wall part; stands for the maximum value of a plurality of distances, the plurality of distances respectively being shortest linear distances in the same horizontal plane from all respective arbitrary points on the thick wall portion to the thin-wall part.

9. A superconducting tunnel junction radiation sensing device comprising a superconductor-tunnel barrier-superconductor structure, characterised in that the superconducting tunnel junction has a lower single-crystal superconductive layer (23), a polycrystalline superconductive layer (24) of a thickness not more than one half of the thickness of the lower single-crystal superconductive layer, a tunnel barrier layer (13) of a material different from the material of the polycrystalline superconductive layer, and an upper superconductive layer (12), in the order of increasing distance from the input side of the device.

10. A superconductive tunnel junction radiation sensing device comprising a superconductor-tunnel barrier-semiconductor structure, characterised in that the superconducting tunnel junction has a lower single-crystal superconductive layer (23), a polycrystalline semiconductive layer (24) of a thickness not more than one half of the thickness of the lower single-crystal superconductive layer, a tunnel barrier layer (13) of a material different from the material of the polycrystalline semiconductor layer (12), and an upper superconductive layer, in the order of increasing distance from the input side of the device.

11. A radiation sensing device as claimed in Claim 9 or Claim 10, characterised in that the lower single-crystal superconductive layer (23) is formed by superposing two or more single-crystal superconductive layers (25,26) of different magnitudes of energy gap in such manner that the closer the single-crystal superconductive layer is to the tunnel barrier layer (13), the smaller is the magnitude of energy gap of the superconductive layer (11).

12. A superconducting tunnel junction radiation sensing device as claimed in Claim 9, characterised in that the thickness of the lower single crystal superconductive layer (23) is greater than the magnetic penetration depth, the sensing device thereby constituting a tunnel-type Josephson device.

## Patentansprüche

1. Supraleitende strahlungsempfindliche Vorrichtung mit Tunnelübergang, die eine Struktur aus Supraleiter/Tunnelsperre/Supraleiter umfaßt, wobei die strahlungsempfindliche Vorrichtung dadurch gekennzeichnet ist, daß ein Teil der Tunnelsperrschicht (13) aus einem dünnwandigen Teil (14) gebildet ist, das aus einem Isolator mit einer Dicke von 0,5 bis 10 nm (5 bis 100 Å) oder einem Halbleiter mit einer Dicke von 0,5 bis 100 nm (5 bis 1000 Å) hergestellt ist, und der andere Teil der Sperrschicht (13) aus einem dickwandigen Teil (15) gebildet ist, das aus einem Isolator oder einem Halbleiter hergestellt ist, dessen Dicke mindestens das Doppelte der Dicke des dünnwandigen Teils beträgt; wobei das dünnwandige Teil diskontinuierlich oder kontinuierlich gleichmäßig über die gesamte Tunnelsperrschicht (13) verteilt ist; und das dünnwandige Teil (14) eine kleinere Gesamtoberfläche als das dickwandige Teil (15) hat.

2. Strahlungsempfindliche Vorrichtung nach Anspruch 1, dadurch gekennzeichnet, daß eine oder beide Supraleiter (11, 12), die auf beiden Seiten der Tunnelsperrschicht angeordnet sind, jeweils gebildet sind, indem zwei oder mehr supraleitende Schichten (16, 17, 18, 19) mit unterschiedlicher Größenordnung der Energielücke in der Weise überlagert werden, daß die Größenordnung der Energielücke der supraleitenden Schicht umso geringer ist, je näher die supraleitende Schicht zur Tunnelsperrschicht ist.

3. Supraleitende strahlungsempfindliche Vorrichtung mit Tunnelübergang, die eine Struktur aus Supraleiter/Tunnel-sperre/Halbleiter umfaßt, wobei die strahlungsempfindliche Vorrichtung dadurch gekennzeichnet ist, daß ein Teil der Tunnelsperrschicht (13) als dünnwandiges Teil (14) ausgebildet ist, das aus einem Isolator mit einer Dicke von 0,5 bis 10 nm (5 bis 100 Å) oder einem Halbleiter mit einer Dicke von 0,5 bis 100 nm (5 bis 1000 Å) hergestellt ist, und der andere Teil der Sperrschicht (13) aus einem dickwandigen Teil (15) gebildet ist, das aus einem Isolator oder einem Halbleiter hergestellt ist, dessen Dicke mindestens das Doppelte der Dicke des dünnwandigen Teils beträgt; wobei das dünnwandige Teil diskontinuierlich oder kontinuierlich gleichmäßig über die gesamte Tunnelsperrschicht (13) verteilt ist; und das dünnwandige Teil (14) eine kleinere Gesamtoberfläche als das dickwandige Teil (15) hat.

4. Strahlungsempfindliche Vorrichtung nach Anspruch 3, dadurch gekennzeichnet, daß der Supraleiter (11), der auf einer Seite der Tunnelsperrschicht angeordnet ist, gebildet ist, indem zwei oder mehr supraleitende Schichten (16, 17) mit unterschiedlicher Größenordnung der Energielücke in der Weise überlagert sind, daß die Größenordnung der Energielücke der supraleitenden Schicht (11) umso geringer ist, je näher die supraleitende Schicht zur Tunnelsperrschicht (13) ist.

5. Strahlungsempfindliche Vorrichtung nach einem der vorstehenden Ansprüche, dadurch gekennzeichnet, daß die oder eine der supraleitenden Schichten (11) aus einer supraleitenden Einkristallschicht (23) gebildet ist; eine polykristalline supraleitende Schicht (24) mit einer Dicke von nicht mehr als der Hälfte der Dicke der supraleitenden Einkristallschicht (23) in dem zumindest mit dem dünnwandigen Teil (14) der Tunnelsperrschicht zusammenhängenden Abschnitt auf der supraleitenden Einkristallschicht (23) ausgebildet ist, und die polykristalline supraleitende Schicht (24) an die Tunnelsperrschicht (13) angrenzt.

6. Strahlungsempfindliche Vorrichtung nach Anspruch 5, dadurch gekennzeichnet, daß die supraleitende Einkristallschicht (23) gebildet ist, indem zwei oder mehr supraleitende Einkristallschichten (25, 26) mit unterschiedlicher Größenordnung der Energielücke in der Weise überlagert sind, daß die Größenordnung der Energielücke der supraleitenden Schicht (11) umso geringer ist, je näher die supraleitende Einkristallschicht der Tunnelsperrschicht (13) ist.

7. Strahlungsempfindliche Vorrichtung nach einem der vorstehenden Ansprüche, dadurch gekennzeichnet, daß der dünnwandige Teil der Tunnelsperrschicht (14) aus einem Isolator mit einer Dicke von 0,5 bis 3 nm (5 bis 30 Å) oder einem Halbleiter mit einer Dicke von 1 bis 10 nm (10 bis 100 Å) besteht, und der dickwandige Teil der Tunnelsperrschicht (15) aus einem Isolator oder Halbleiter hergestellt ist, dessen Dicke nicht weniger als das Fünffache der Dicke des dünnwandigen Teils (14) beträgt.

8. Strahlungsempfindliche Vorrichtung nach einem der vorstehenden Ansprüche, dadurch gekennzeichnet, daß die Bedingung der folgenden Gleichung erfüllt wird:$\text{0 < l < (} \sqrt{\text{S}} \text{-} \sqrt{{\text{S}}_{\text{1}}} \text{)/} \sqrt{\text{π}}$ worin S die Gesamtoberfläche der Tunnelsperrschicht bedeutet; S₁ die Gesamtoberfläche des dünnwandigen Teils bedeutet; den Höchstwert einer Anzahl von Abständen bedeutet, wobei die Anzahl der Abstände jeweils die kürzesten linearen Abstände in der gleichen waagerechten Ebene von allen entsprechenden willkürlichen Punkten auf dem dickwandigen Abschnitt zum dünnwandigen Teil sind.

9. Supraleitende strahlungsempfindliche Vorrichtung mit Tunnelübergang, die eine Struktur aus Supraleiter/Tunnel-sperre/Supraleiter umfaßt, dadurch gekennzeichnet, daß der supraleitende Tunnelübergang in der Reihenfolge des zunehmenden Abstands von der Eingabeseite der Vorrichtung eine untere supraleitende Einkristallschicht (23), eine polykristalline supraleitende Schicht (24) mit einer Dicke von nicht mehr als der Hälfte der Dicke der unteren supraleitenden Einkristallschicht, eine Tunnelsperrschicht (13) aus einem Material, das sich vom Material der polykristallinen supraleitenden Schicht unterscheidet, und eine obere supraleitende Schicht (12) umfaßt.

10. Supraleitende strahlungsempfindliche Vorrichtung mit Tunnelübergang, die eine Struktur aus Supraleiter/Tunnel-sperre/Halbleiter umfaßt, dadurch gekennzeichnet, daß der supraleitende Tunnelübergang in der Reihenfolge des zunehmenden Abstands von der Eingabeseite der Vorrichtung eine untere supraleitende Einkristallschicht (23), eine polykristalline Halbleiterschicht (24) mit einer Dicke von nicht mehr als der Hälfte der Dicke der unteren supraleitenden Einkristallschicht, eine Tunnelsperrschicht (13) aus einem Material, das sich vom Material der polykristallinen Halbleiterschicht (12) unterscheidet, und eine obere supraleitende Schicht umfaßt.

11. Strahlungsempfindliche Vorrichtung nach Anspruch 9 oder 10, dadurch gekennzeichnet, daß die untere supraleitende Einkristallschicht (23) gebildet ist, indem zwei oder mehr supraleitende Einkristallschichten (25, 26) mit unterschiedlicher Größenordnung der Energielücke in der Weise überlagert sind, daß die Größenordnung der Energielücke der supraleitenden Schicht (11) umso geringer ist, je näher die supraleitende Einkristallschicht zur Tunnelsperrschicht (13) ist.

12. Supraleitende strahlungsempfindliche Vorrichtung mit Tunnelübergang nach Anspruch 9, dadurch gekennzeichnet, daß die Dicke der unteren supraleitenden Einkristallschicht (23) größer als die magnetische Eindringtiefe ist, wodurch der Fühler eine Josephson-Vorrichtung vom Tunnel-Typ bildet.

## Revendications

1. Un dispositif de détection de rayonnement à jonction tunnel supraconductrice comprenant une structure supraconducteur-barrière tunnel-supraconducteur, le dispositif de détection de rayonnement étant caractérisé en ce qu'une partie de la couche de barrière tunnel (13) est formée par une partie à paroi mince (14) constituée par un isolant de 0,5 à 10 nm (5 à 100 Å) d'épaisseur, ou par un semiconducteur de 0,5 à 100 nm (5 à 1000 Å) d'épaisseur, et l'autre partie de la couche de barrière (13) est formée par une partie à paroi épaisse (15) constituée par un isolant ou un semiconducteur ayant une épaisseur au moins deux fois supérieure à celle de la partie à paroi mince; la partie à paroi mince étant répartie uniformément, de manière discontinue ou continue, sur toute l'étendue de la couche de barrière tunnel (13); et la partie à paroi mince (14) ayant une aire de surface totale inférieure à celle de la partie à paroi épaisse (15).

2. Un dispositif de détection de rayonnement selon la revendication 1, caractérisé en ce que l'un ou l'autre des supraconducteurs (11, 12), ou les deux, qui sont disposés de part et d'autre de la couche de barrière tunnel, sont respectivement formés en superposant au moins deux couches supraconductrices (16, 17, 18, 19) ayant des bandes interdites de largeur différente, de manière que la largeur de la bande d'énergie interdite de la couche supraconductrice soit d'autant plus faible que la couche supraconductrice est proche de la couche de barrière tunnel.

3. Un dispositif de détection de rayonnement à jonction tunnel supraconductrice comprenant une structure supraconducteur-barrière tunnel-semiconducteur, le dispositif de détection de rayonnement étant caractérisé en ce qu'une partie de la couche de barrière tunnel (13) est formée par une partie à paroi mince (14) constituée par un isolant de 0,5 à 10 nm (5 à 100 Å) d'épaisseur, ou par un semiconducteur de 0,5 à 100 nm (5 à 1000 Å) d'épaisseur, et l'autre partie de la couche de barrière (13) est formée par une partie à paroi épaisse (15) constituée par un isolant ou un semiconducteur ayant une épaisseur au moins deux fois supérieure à celle de la partie à paroi mince; la partie à paroi mince étant répartie uniformément, de manière discontinue ou continue, sur toute l'étendue de la couche de barrière tunnel (13); et la partie à paroi mince (14) ayant une aire de surface totale inférieure à celle de la partie à paroi épaisse (15).

4. Un dispositif de détection de rayonnement selon la revendication 3, caractérisé en ce que le supraconducteur (11) qui est disposé d'un côté de la couche de barrière tunnel est formé en superposant au moins deux couches supraconductrices (16, 17) ayant des largeurs de bande d'énergie interdite différentes, d'une manière que la largeur de la bande d'énergie interdite de la couche supraconductrice (11) soit d'autant plus faible que la couche supraconductrice est proche de la couche de barrière tunnel (13).

5. Un dispositif de détection de rayonnement selon l'une quelconque des revendications précédentes, caractérisé en ce que la couche supraconductrice (11), ou l'une d'elles, est formée par une couche supraconductrice monocristalline (23); et une couche supraconductrice polycristalline (24) ayant une épaisseur qui n'est pas supérieure à la moitié de l'épaisseur de la couche supraconductrice monocristalline (23) est formée sur la couche supraconductrice monocristalline (23) dans la partie qui est contigüe au moins à la partie de paroi mince (14) de la couche de barrière tunnel, et la couche supraconductrice polycristalline (24) est adjacente à la couche de barrière tunnel (13).

6. Un dispositif de détection de rayonnement selon la revendication 5, caractérisé en ce que la couche supraconductrice monocristalline (23) est formée en superposant au moins deux couches supraconductrices monocristallines (25, 26) ayant des largeurs de bande d'énergie interdite différentes, d'une manière telle que la largeur de la bande d'énergie interdite de la couche supraconductrice (11) soit d'autant plus faible que la couche supraconductrice monocristalline est proche de la couche de barrière tunnel (13).

7. Un dispositif de détection de rayonnement selon l'une quelconque des revendications précédentes, caractérisé en ce que la partie à paroi mince de la couche de barrière tunnel (14) est formée par un isolant de 0,5 à 3 nm (5 à 30 Å) d'épaisseur, ou par un semiconducteur de 1 à 10 nm (10 à 100 Å) d'épaisseur, et la partie à paroi épaisse de la couche de barrière tunnel (15) est formée par un isolant ou par un semiconducteur ayant une épaisseur qui n'est pas supérieure à cinq fois l'épaisseur de la partie à paroi mince (14).

8. Un dispositif de détection de rayonnement selon l'une quelconque des revendications précédentes, caractérisé en ce qu'il satisfait la condition de l'expression suivante :$\text{0 < ℓ < (} \sqrt{\text{S}} \text{-} \sqrt{{\text{S}}_{\text{1}}} \text{) /} \sqrt{\text{π}}$ dans laquelle S désigne l'aire de surface totale de la couche de barrière tunnel; S₁ désigne l'aire de surface totale de la partie à paroi mince; ℓ désigne la valeur maximale parmi un ensemble de distances, les distances de l'ensemble de distances étant respectivement les distances linéaires les plus courtes, dans le même plan horizontal, à partir de tous les points arbitraires respectifs sur la partie à paroi épaisse, jusqu'à la partie à paroi mince.

9. Un dispositif de détection de rayonnement à jonction tunnel supraconductrice comprenant une structure supraconducteur-barrière tunnel-supraconducteur, caractérisé en ce que la jonction tunnel supraconductrice comporte une couche supraconductrice monocristalline inférieure (23), une couche supraconductrice polycristalline (24) d'une épaisseur qui n'est pas supérieure à la moitié de l'épaisseur de la couche supraconductrice monocristalline inférieure, une couche de barrière tunnel (13) en un matériau qui est différent du matériau de la couche supraconductrice polycristalline, et une couche supraconductrice supérieure (12), dans l'ordre des distances croissantes à partir du côté d'entrée du dispositif.

10. Un dispositif de détection de rayonnement à jonction tunnel supraconductrice, comprenant une structure supraconducteur-barrière tunnel-semiconducteur, caractérisé en ce que la jonction tunnel supraconductrice comprend une couche supraconductrice monocristalline inférieure (23), une couche semiconductrice polycristalline (24) d'une épaisseur qui n'est pas supérieure à la moitié de l'épaisseur de la couche supraconductrice monocristalline inférieure, une couche de barrière tunnel (13) en un matériau qui est différent du matériau de la couche semiconductrice polycristalline (12), et une couche supraconductrice supérieure, dans l'ordre des distances croissantes à partir du côté d'entrée du dispositif.

11. Un dispositif de détection de rayonnement selon la revendication 9 ou la revendication 10, caractérisé en ce que la couche supraconductrice monocristalline inférieure (23) est formée en superposant au moins deux couches supraconductrices monocristallines (25, 26) ayant des largeurs de bande d'énergie interdite différentes, d'une manière telle que la largeur de la bande d'énergie interdite de la couche supraconductrice (11) soit d'autant plus faible que la couche supraconductrice monocristalline est proche de la couche de barrière tunnel (13).

12. Un dispositif de détection de rayonnement à jonction tunnel supraconductrice selon la revendication 9, caractérisé en ce que l'épaisseur de la couche supraconductrice monocristalline inférieure (23) est supérieure à la profondeur de pénétration magnétique, le dispositif de détection constituant ainsi un dispositif Josephson de type tunnel.
